(19) Europäisches Patentamt
European Patent Office
Office européen des brevets

(11) **EP 2 174 153 B1**

(12) **EUROPÄISCHE PATENTSCHRIFT**

(45) Veröffentlichungstag und Bekanntmachung des Hinweises auf die Patenterteilung:
**29.12.2010   Patentblatt 2010/52**

(51) Int Cl.:
***G01R 33/07*** *(2006.01)*

(21) Anmeldenummer: 08785622.5

(22) Anmeldetag: **19.08.2008**

(86) Internationale Anmeldenummer:
**PCT/EP2008/006808**

(87) Internationale Veröffentlichungsnummer:
**WO 2009/030361 (12.03.2009 Gazette 2009/11)**

(54) **KALIBRIERBARER MEHRDIMENSIONALER MAGNETISCHER PUNKTSENSOR**

CALIBRATABLE MULTIDIMENSIONAL MAGNETIC POINT SENSOR

CAPTEUR MAGNÉTIQUE PONCTUEL MULTIDIMENSIONNEL ÉTALONNABLE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **31.08.2007   DE 102007041230**

(43) Veröffentlichungstag der Anmeldung:
**14.04.2010   Patentblatt 2010/15**

(73) Patentinhaber: **Fraunhofer-Gesellschaft zur Förderung der angewandten Forschung e.V.
80686 München (DE)**

(72) Erfinder:
• **HOHE, Hans-Peter
91332 Heiligenstadt (DE)**
• **HACKNER, Michael
93155 Hemau OT Haag (DE)**
• **STAHL-OFFERGELD, Markus
91058 Erlangen (DE)**

(74) Vertreter: **Hersina, Günter
Schoppe, Zimmermann, Stoeckeler & Zinkler
Postfach 246
82043 Pullach (DE)**

(56) Entgegenhaltungen:
• **DEMIERRE M ET AL: "Reference magnetic actuator for self-calibration of a very small Hall sensor array" SENSORS AND ACTUATORS A, ELSEVIER SEQUOIA S.A., LAUSANNE, CH, Bd. 97-98, 1. April 2002 (2002-04-01), Seiten 39-46, XP004361580 ISSN: 0924-4247**
• **SCHOTT C ET AL: "Single-chip 3-D silicon Hall sensor" SENSORS AND ACTUATORS A, ELSEVIER SEQUOIA S.A., LAUSANNE, CH, Bd. 82, Nr. 1-3, 1. Mai 2000 (2000-05-01), Seiten 167-173, XP004198257 ISSN: 0924-4247**
• **KAYAL ET AL: "Automatic calibration of Hall sensor microsystems" MICROELECTRONICS JOURNAL, MACKINTOSH PUBLICATIONS LTD. LUTON, GB, Bd. 37, Nr. 12, 11. November 2006 (2006-11-11), Seiten 1569-1575, XP005728300 ISSN: 0026-2692**

**Beschreibung**

Die vorliegende Erfindung bezieht sich auf Magnetfeldsensoren und insbesondere auf Hall-Sensoren zur Erfassung von räumlichen Komponenten eines Magnetfeldes in einem Referenzpunkt, die insbesondere im Messbetrieb kalibrierbar sind, sowie auf die dort eingesetzten Kalibrierungs- und Messverfahren.

Auf dem Hall-Effekt basierende Hall-Sensorelemente werden in der Technik neben der Vermessung von Magnetfeldern nach Betrag und Richtung, häufig auch für kontaktfreie, berührungslose Signalgeber zur verschleißfreien Erfassung der Stellung von Schaltern oder Stellgliedern eingesetzt. Eine weitere Einsatzmöglichkeit besteht in der Strommessung, wobei ein Hall-Sensorelement in der Nähe einer Leiterbahn angeordnet wird und den Strom in der Leiterbahn über die Erfassung des durch den Strom in der Leiterbahn erzeugten Magnetfeldes kontaktlos bemisst. In der praktischen Anwendung haben sich Hall-Sensorelemente insbesondere durch ihre relativ starke Unempfindlichkeit gegenüber äußeren Einflüssen, wie z. B. Verschmutzungen und so weiter, ausgezeichnet.

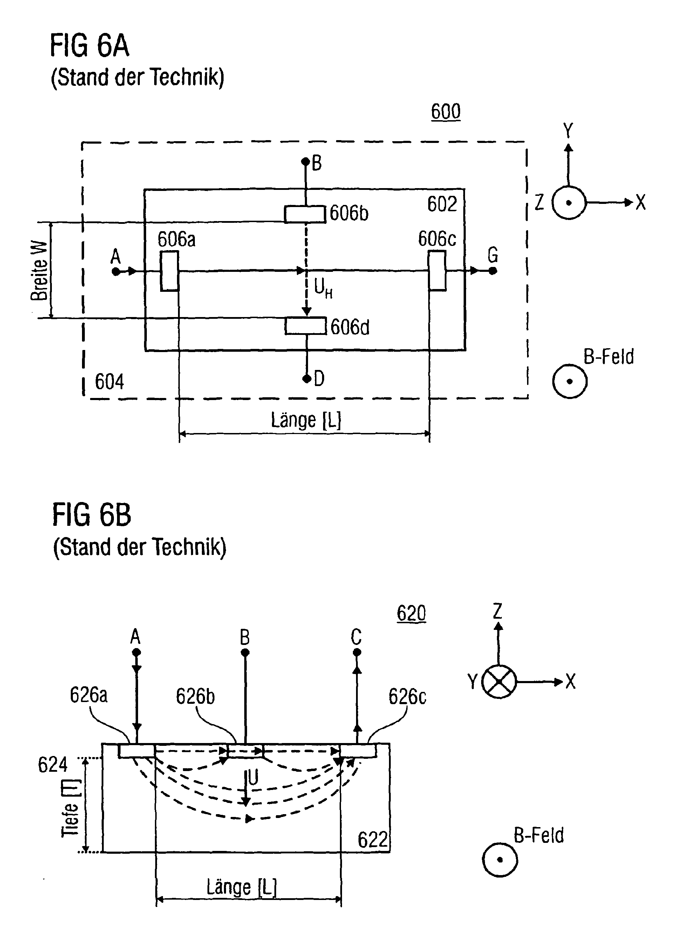

In der Technik sind sowohl sogenannte horizontale oder laterale Hall-Sensorelemente als auch vertikale Hall-Sensorelemente bekannt, wobei in Fig. 6a ein horizontales Hall-Sensorelement und in Fig. 6b ein vertikales Hall-Sensorelement gemäß dem Stand der Technik beispielhaft dargestellt sind.

Ein Hall-Sensorelement ist im Allgemeinen aus einem Halbleiterplättchen mit vier Kontaktanschlüssen, die zur elektrischen Verbindung mit einer externen Ansteuerschaltung vorgesehen sind, aufgebaut. Von den vier Kontaktanschlüssen eines Hall-Sensorelementes sind zwei Kontaktanschlüsse zur Betriebsstromeinprägung durch einen aktiven Halbleiterbereich vorgesehen, während die anderen beiden Kontaktanschlüsse vorgesehen sind, um die Hall-Spannung zu erfassen. Setzt man das von dem Betriebsstrom durchflossene Halbleiterplättchen einem Magnetfeld mit der Induktion $\underline{B}$ aus, so kommt es zu einer Ablenkung der Strombahnen, die durch die auf die bewegten Ladungsträger im magnetischen Feld einwirkende "Lorenz-Kraft" verursacht wird. Die Hall-Spannung ergibt sich senkrecht zur Richtung des Stromflusses und senkrecht zum anliegenden Magnetfeld in dem aktiven Halbleitergebiet.

Wie nun in Fig. 6a prinzipiell dargestellt ist, ist ein horizontales Hall-Sensorelement 600 gemäß dem Stand der Technik im Allgemeinen aus einem n-dotierten Halbleiterbereich 602 auf einem p-dotierten Halbleitersubstrat 604 aufgebaut. Als horizontal wird ein Hall-Sensorelement bezeichnet, das parallel zu einer Chipoberfläche (x-y-Ebene) angeordnet ist.

Der n-dotierte aktive Bereich 602 ist üblicherweise über vier Kontaktelektroden 606a-d, die jeweils paarweise gegenüberliegend in dem aktiven Bereich 602 angeordnet sind, mit einer externen Ansteuer- bzw. Auswertelogik verbunden. Die Ansteuer- bzw. Auswertelogik ist der Übersichtlichkeit halber in Fig. 6 nicht dargestellt. Die vier Kontaktelektroden 606a-d unterteilen sich in zwei gegenüberliegende Steuerstromkontaktelektroden 606a und 606c, die vorgesehen sind, um einen Stromfluss $I_H$ durch den aktiven Bereich 602 zu erzeugen, und ferner in zwei gegenüberliegende Spannungsabgriffskontaktelektroden 606b und 606d, die vorgesehen sind, um eine Hall-Spannung $U_H$, die bei einem anliegenden Magnetfeld $\underline{B}$ senkrecht zu dem Stromfluss in dem aktiven Bereich 602 und dem anliegenden Magnetfeld auftritt, als Sensorsignal abzugreifen. Indem nun der Stromfluss $I_H$ zwischen verschiedenen Kontaktelektroden eingeprägt und entsprechend die Hall-Spannung $U_H$ an den anderen Kontaktelektroden senkrecht zum Stromfluss abgegriffen wird, lassen sich Kompensationsverfahren implementieren, die es ermöglichen, Toleranzen, die in den Hall-Sensoren beispielweise aufgrund von Herstellungstoleranzen usw. auftreten, über mehrere Messzyklen zu kompensieren.

Wie aus dem in Fig. 6a dargestellten horizontalen Hall-Sensorelement 600 ersichtlich ist, ist der aktive Bereich zwischen den Kontaktanschlüssen 606a-d definiert, so dass der aktive Bereich eine effektive Länge L und eine effektive Breite W aufweist. Die anhand von Fig. 6a dargestellten horizontalen Hall-Sensorelemente 600 sind relativ einfach mit herkömmlichen CMOS-Prozessen (CMOS = Complementary Metal Oxide Semiconductor) zur Herstellung von Halbleiterstrukturen herstellbar.

Neben den horizontalen Hall-Sensorelementen sind im Stand der Technik ferner Realisierungen sogenannter vertikaler Hall-Sensoranordnungen bekannt, die auch den Einsatz von Standard-Halbleiterherstellungstechnologien, beispielsweise von CMOS-Prozessen, ermöglichen. Ein Beispiel für ein vertikales Hall-Sensorelement 620 ist prinzipiell in Fig. 6b dargestellt, wobei mit vertikal eine Ebene senkrecht zur Ebene der Chipoberfläche (X-Y-Ebene) gemeint ist. Bei dem in Fig. 6b dargestellten vertikalen Hall-Sensorelement 620 erstreckt der sich vorzugsweise n-dotierte aktive Halbleiterbereich 622 in Form einer Wanne in einem p-dotierten Halbleitersubstrat 624, wobei der aktive Halbleiterbereich 622 eine Tiefe T aufweist. Wie nun in Fig. 6b dargestellt ist, weist das vertikale Hall-Sensorelement drei Kontaktbereiche 626a-c auf, die angrenzend an die Hauptoberfläche des Halbleitersubstrats 624 in demselben angeordnet sind, wobei sich die Kontaktanschlüsse 626a-c alle in dem aktiven Halbleiterbereich 622 befinden. Aufgrund der drei Kontaktbereiche wird diese Variante von vertikalen Hall-Sensorelementen auch 3-Pin-Sensor genannt.

Das in Fig. 6b dargestellte vertikale Hall-Sensorelement 620 weist also drei Kontaktbereiche 626a-c entlang der Hauptoberfläche des aktiven Halbleiterbereichs 622 auf, wobei der Kontaktbereich 626a mit einem Kontaktanschluss A verbunden ist, der Kontaktbereich 626b mit einem Kontaktanschluss B verbunden ist und wobei der Kontaktbereich 626c mit einem Kontaktanschluss C verbunden ist. Wird nun zwischen die beiden Kontaktanschlüsse A und C eine Spannung angelegt, so stellt sich ein Stromfluss $I_H$ durch den aktiven Halbleiterbereich 622 ein, und am Kontaktanschluss B kann nun eine Hall-Spannung $U_H$, die senkrecht zum Stromfluss $I_H$ und zum Magnetfeld $\overline{B}$ ausgerichtet ist, gemessen werden. Die effektiv wirksamen Bereiche des aktiven Halbleiterbereichs 622 sind durch die Tiefe T des aktiven Halbleiterbereichs 622 und die Länge L entsprechend dem Abstand zwischen den Stromeinspeisungskontaktelektroden 626a und 626c vorgegeben.

Horizontale und vertikale Hall-Sensoren, sowie die Verfahren zur Reduzierung von Offsets, die durch Bauelementtoleranzen wie beispielsweise Verunreinigungen, Asymmetrien, piezoelektrische Effekte, Alterungserscheinungen usw. entstehen, beispielsweise mit dem Spinning-Current-Verfahren, sind in der Literatur bereits bekannt, z. B. R. S. Popovic, "Hall Effect Devices, Magnetic Sensors and Characterization of Semiconductors", Adam Hilger, 1991, ISBN 0-7503-0096-5. Häufig bestehen vertikale Sensoren, die Spinning-Current betrieben werden, aus zwei, oder aus vier Einzelsensoren, wie dies beispielsweise die DE 101 50 955 und DE 101 50 950 beschreiben.

Ferner gibt es neben der Variante der 3-pinnigen vertikalen Hall-Sensorelemente auch sogenannte 5-pinninge vertikale Hall-Sensorelemente, die ebenfalls in DE 101 50 955 und DE 101 50 950 beschrieben werden. Auch bei den 5-Pin-Hall-Sensorelementen besteht die Möglichkeit mittels eines Kompensationsverfahrens, das sich über mehrere Messphasen erstreckt, eine um Toleranzen der einzelnen Bauteile kompensierte Messung durchzuführen, beispielsweise könnte auch hier ein Spinning-Current-Verfahren eingesetzt werden.

Die Spinning-Current-Technik besteht nun darin, die Messrichtung zur Erfassung der Hall-Spannung an dem Hall-Sensorelement ständig mit einer bestimmten Taktfrequenz um beispielsweise 90° zyklisch weiter zu drehen und über alle Messsignale einer vollen Drehung um 360° aufzusummieren. Bei einem Hall-Sensorelement mit vier Kontaktbereichen, von denen jeweils zwei Kontaktbereiche paarweise zueinander zugeordnet sind, wird daher jedes der Kontaktpaare je nach Spinning-Current-Phase sowohl als Steuerstromkontaktbereiche zur Stromeinspeisung als auch als Messkontaktbereiche zum Abgreifen des Hall-Signals genutzt. So fließt in einer Spinning-Current-Phase bzw. in einem Spinning-Current-Zyklus der Betriebsstrom (Steuerstrom $I_H$) zwischen zwei zugeordneten Kontaktbereichen, wobei die Hall-Spannung an den beiden anderen einander zugeordneten Kontaktbereichen abgegriffen wird.

Beim nächsten Zyklus wird dann die Messrichtung um 90° weitergedreht, so dass die Kontaktbereiche, die im vorangehenden Zyklus zum Abgreifen der Hall-Spannung eingesetzt wurden, nunmehr zur Einspeisung des Steuerstroms dienen. Durch die Summation über alle vier Zyklen bzw. Phasen heben sich herstellungs- oder materialbedingte Offset-Spannungen annähernd gegenseitig auf, so dass nur die tatsächlich magnetfeldabhängigen Anteile des Signals übrig bleiben. Diese Vorgehensweise ist natürlich auch auf eine größere Anzahl von Kontaktpaaren anwendbar, wobei beispielsweise bei vier Kontaktpaaren (mit acht Kontaktbereichen) die Spinning-Current-Phasen um 45° zyklisch weiter gedreht werden, um alle Messsignale über einer vollen Drehung um 360° aufsummieren zu können.

Bei horizontalen Hall-Sensoren werden ebenfalls häufig vier Sensoren verwendet, da bei geeigneter Anordnung der Offset durch räumlichen Spinning-Current-Betrieb zusätzlich stark reduziert werden kann, siehe z.B. DE 199 43 128.

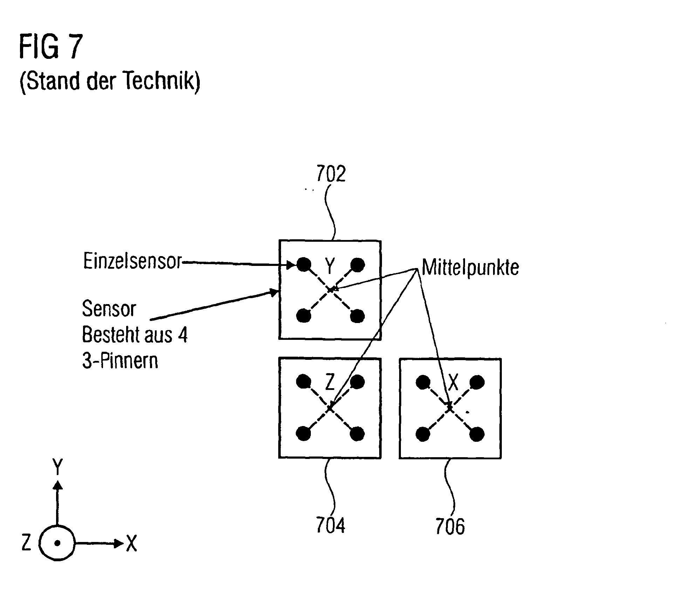

Soll ein Magnetfeld für mehrere Raumrichtungen gemessen werden, so werden hierzu zumeist getrennte Hall-Sensorelemente verwendet. Die Verwendung getrennter Sensoren, beispielsweise zur Erfassung der drei Raumrichtungen eines Magnetfeldes, bringt generell die Problematik mit sich, dass das zu vermessende Magnetfeld nicht in einem Punkt, sondern in drei verschiedenen Punkten gemessen wird. Fig. 7 verdeutlicht diesen Aspekt, wobei Fig. 7 drei Hall-Sensoren 702, 704 und 706 zeigt. Der erste Hall-Sensor 702 ist zur Erfassung einer y-Raumkomponente, der zweite Hall-Sensor 704 ist zur Erfassung einer z-Raumkomponente und der dritte Hall-Sensor 706 ist zur Erfassung einer x-Raumkomponente vorgesehen. Die Einzelsensoren 702, 704 und 706 messen dabei die entsprechenden Raumkomponenten eines Magnetfeldes näherungsweise in den jeweiligen Mittelpunkten der Einzelsensoren.

Ein Einzelsensor kann wiederum aus mehreren Hall-Sensorelementen aufgebaut sein. Fig. 7 zeigt beispielhaft drei Einzelsensoren, die jeweils vier Hall-Sensorelemente aufweisen, wobei in Fig. 7 beispielhaft von einem horizontalen Hallsensor 704 ausgegangen wird, der eine z-Komponente des zu messenden Magnetfeldes erfasst, und von je einem vertikalen Hallsensor 702 und 706 für y- bzw. x-Komponente des zu messenden Magnetfeldes. Die Anordnung zur Erfassung der räumlichen Magnetfeldkomponenten, wie beispielhaft in Fig. 7 dargestellt, weist die Problematik auf, dass das Magnetfeld nicht in einem Punkt gemessen werden kann, sondern in den jeweiligen Mittelpunkten der Einzelsensoren. Dies bringt zwangsläufig eine Verfälschung mit sich, da keine exakte Auswertung des Magnetfeldes basierend auf den an unterschiedlichen Orten erfassten Magnetfeldkomponenten des Magnetfeldsensors möglich ist.

Ein weiterer Aspekt bei der Erfassung und Auswertung von Magnetfeldern mittels Hall-Sensorelementen ist die Kalibrierung der Einzelelemente. Gemäß dem Stand der Technik werden Hall-Sensorelemente zumeist mit sogenannten Erregerleitungen versehen, die es erlauben, ein definiertes Magnetfeld im Messpunkt eines Einzelsensors zu erzeugen, um anschließend durch Vergleich bzw. Zuordnung der gemessenen Hall-Spannung zu dem definierten Magnetfeld eine Kalibrierung des Sensors zu erreichen.

Mit Erregerleitern ist es möglich ein künstliches Magnetfeld an einem Hall-Sensor zu erzeugen, mit dem ein einfacher Wafertest, d.h. ein Test direkt auf dem Substrat, sowie ein Selbsttest und eine Empfindlichkeitskalibrierung im laufenden Betrieb möglich ist, vergleiche Janez Trontelj, "Optimization of Integrated Magnetic Sensor by Mixed Signal Processing, Proceedings of the 16th IEEE Vol. 1. Dies ist in sicherheitskritischen Bereichen, z. B. im Automobilbereich oder auch in der Medizintechnik, von besonderem Interesse, da hiermit eine Selbstüberwachung der Sensoren auch im Betrieb möglich wird.

Werden nun beispielsweise zur Erfassung der räumlichen Komponenten eines Magnetfeldes mehrere Einzelsensoren, wie beispielhaft in Fig. 7 gezeigt, verwendet, so benötigt jeder Einzelsensor eine entsprechende Erregerleitung zur Kalibrierung, und die Einzelsensoren werden weiterhin einzeln kalibriert. Der Kalibrierungsaufwand skaliert also mit der Anzahl von Einzelsensorelementen und erhöht sich also im Falle der räumlichen Erfassung von drei Magnetfeldkomponenten um das Dreifache gegenüber dem Kalibrierungsaufwand eines Einzelsensors.

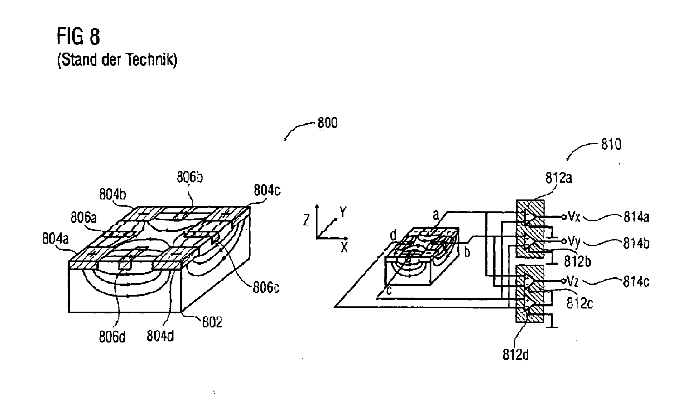

Ein Ansatz, um eine Auswertung eines Magnetfeldes zu ermöglichen, d.h. eine Messung in einem Punkt zu erfassen, ist ein 3D-Sensor der Ecole Polytechnique Federal Lausanne EPFL, vergleiche C. Schott, R. S. Popovic, "Integrated 3D Hall Magnetic Field Sensor", Transducers '99, June 7-10, Sensai, Japan, VOL. 1, PP. 168-171, 1999. Fig. 8 zeigt schematisch einen solchen Hall-Sensor 800, der auf ein Halbleitersubstrat 802 implementiert ist. Der 3D-Sensor weist zunächst vier Kontaktflächen 804a-d auf, über die Ströme in das Halbleitersubstrat 802 eingeprägt werden können. Der 3D-Sensor weist ferner vier Messkontaktflächen 806a-d auf, über die die verschiedenen Magnetfeldkomponenten erfasst werden können. In Fig. 8 ist auf der rechten Seite eine Verschaltung 810 dargestellt. Die gezeigte Verschaltung, die sich aus vier Operationsverstärkern 812a-d zusammensetzt, wertet die zu den einzelnen Magnetfeldkomponenten proportionalen Hall-Spannungen aus, und gibt die entsprechenden Komponenten an den Anschlüssen 814a-c, in Form der Signale Vx, Vy und Vz aus.

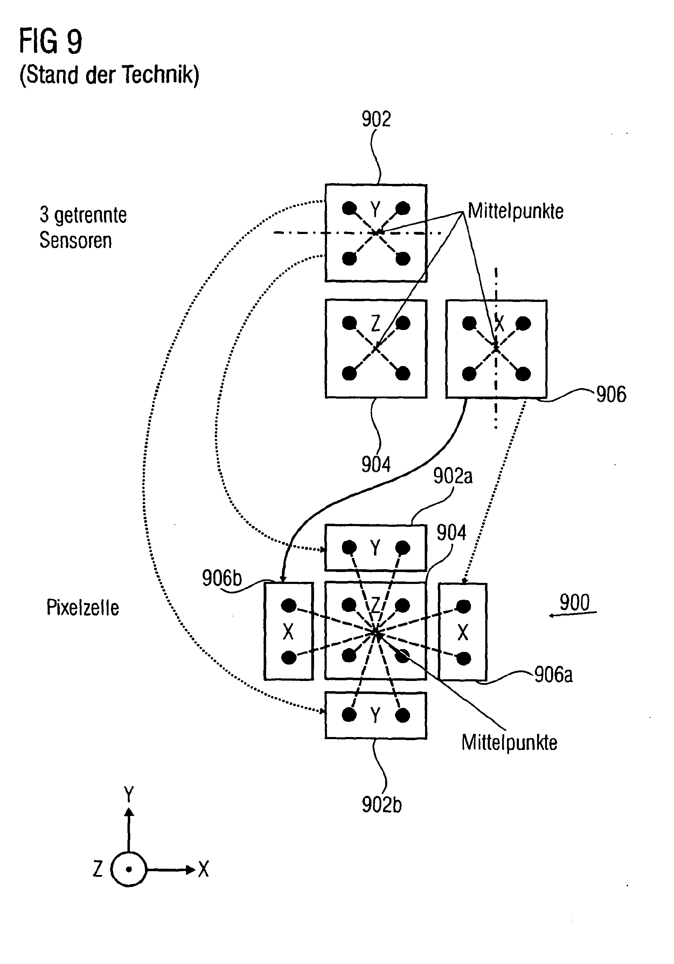

Der dargestellte Sensor bringt die Problematik mit sich, dass er nur durch ein definiertes von außen erzeugtes Magnetfeld kalibriert werden kann und keine eigene Erregerleitung aufweist. Ferner kann dieser Sensor aufgrund seines Aufbaus und seiner Funktionsweise nicht mit einem Kompensationsverfahren, z.B. Spinning-Current-Verfahren betrieben werden. Weiterhin besteht ein Problem in der in Fig. 8 gezeigten Anordnung darin, dass ein solcher Halbleiter-Baustein aufgrund von Verunreinigungen des Hälbleitermaterials, Asymmetrien in der Kontaktierung, Varianzen in der Kristallstruktur usw. Offset-Spannungen aufweist, die nicht über eine entsprechende Spinning-Current-taugliche Kompensationsverschaltung unterdrückt werden können. Der Sensor misst somit zwar Magnetfeldkomponenten in einem fokussierten Punkt, besitzt aber einen hohen Offset und ist daher nur eingeschränkt für präzise Messungen geeignet. Fig. 9 zeigt einen kompensationsfähigen (Spinning-Current) 3D-Sensor, der räumliche Magnetfeldkomponenten in einem Messpunkt erfasst und von Enrico Schurig in "Highly Sensitive Vertical Hall Sensors in CMOS Technology", Hartung-Corre Verlag Konstanz, 2005, Reprinted from EPFL Thesis N° 3134 (2004), ISSN 1438-0609, ISBN 3-86628-023-8 WW. 185ff erörtert wird. In Fig. 9 oben ist zunächst der aus den drei Einzelsensoren bestehende 3D-Sensor aus Fig. 7 gezeigt. Fig. 9 zeigt im oberen Teil drei getrennte Einzelsensoren 902, 904 und 906 zur Erfassung der räumlichen Magnetfeldkomponenten. In Fig. 9 ist im unteren Teil eine alternative Anordnung der Einzelsensoren gezeigt. Bei dieser Anordnung wird der Sensor 904 unverändert beibehalten, da der Messpunkt des Sensors 904 in der Mitte der Anordnung 900 in Fig. 9 liegt, ferner bestehen die beiden Einzelsensoren 902 und 906 aus Einzelelementen, die trennbar sind. Der Sensor 902 wird also jetzt in zwei Sensorteile 902a und 902b aufgeteilt und symmetrisch um den Mittelpunkt des Sensorelements 904 angeordnet. Eine analoge Verfahrensweise wird dem Sensor 906 zuteil, so dass auch dieses in zwei Sensorteile 906a und 906b aufgeteilt wird, die symmetrisch um den Mittelpunkt des Sensorelements 904 angeordnet sind, entlang der entsprechenden Raumachse. Durch die symmetrische Anordnung der einzelnen Sensorelemente wird nun das magnetische Feld in einem Punkt erfasst, der im geometrischen Zentrum der Anordnung liegt.

Zusammenfassend lässt sich somit sagen, dass im Bereich der konventionellen Technik zur Messung mehrdimensionaler Magnetfelder Einzelsensoren, die symmetrisch um einen Mittelpunkt angeordnet sind, zum Einsatz kommen können. Solche Anordnungen können insbesondere bei Winkelsensoren realisiert werden, wo ein Magnetfeld durch alle Sensoren in einem Punkt gemessen werden soll. Problematisch bei diesen Anordnungen ist die Überwachung, Kalibrierung und das Testen der Sensoren.

Es ist die Aufgabe der vorliegenden Erfindung einen Magnetfeldsensor zur mehrdimensionalen Erfassung von Magnetfeldkomponenten in einem Referenzpunkt zu schaffen, dessen Toleranzen effizient kompensierbar sind, der sowohl zuverlässig und unaufwendig kalibrierbar ist, wobei eine Kalibrierung im Messbetrieb durchführbar ist, und der aufwandgünstig und effizient sowohl in einem On-Wafer-Test als auch im Betrieb testbar ist.

Diese Aufgabe wird durch kalibrierbaren Magnetfeldsensor gemäß Anspruch 1 und ein Verfahren zum Kalibrieren eines Magnetfeldsensors im Messbetrieb gemäß Anspruch 16 gelöst. Die vorliegende Erfindung schafft in einem Ausführungsbeispiel einen kalibrierbaren Magnetfeldsensor zur Erfassung einer ersten und einer zweiten räumlichen Komponente eines Magnetfeldes in einem Referenzpunkt, wobei das Magnetfeld eine erste und eine zweite Messfeldkomponente und/oder eine erste und zweite Kalibrierungsfeldkomponente aufweist, mit einer ersten Sensorelementanordnung, die wenigstens ein erstes und ein zweites Sensorelement aufweist, zur Erfassung der ersten Magnetfeldkomponente, die eine erste Messfeldkomponente und/oder eine erste Kalibrierungsfeldkomponente aufweist, bezüglich einer ersten Raumachse in dem Referenzpunkt. Der Magnetfeldsensor umfasst ferner eine zweite Sensorelementanordnung zur Erfassung der zweiten Magnetfeldkomponente, die eine zweite Messfeldkomponente und/oder eine zweite Kalibrierungsfeldkomponente aufweist, bezüglich einer zweiten Raumachse im Referenzpunkt. Ferner umfasst der Magnetfeldsensor eine Erregerleitung, die so bezüglich der ersten Sensorelementanordnung angeordnet ist, dass bei einer Einprägung eines vorgegebenen Stroms in die Erregerleitung ein Paar von unterschiedlichen vorgegebenen Kalibrierungsfeldkomponenten in dem ersten Sensorelement und in dem zweiten Sensorelement bezüglich der ersten Raumachse in der ersten Sensorelementanordnung erzeugt wird, wobei die zwei Raumachsen entlang linear unabhängigen Ortsvektoren verlaufen.

Die vorliegende Erfindung schafft in einem weiteren Ausführungsbeispiel einen im Messbetrieb kalibrierbaren Magnetfeldsensor zur Erfassung einer ersten, zweiten und dritten räumlichen Komponente $B_z$, $B_y$ und $B_x$ eines Magnetfeldes in einem Referenzpunkt, wobei das Magnetfeld eine erste, zweite und dritte Messfeldkomponente $B_{Mz}$, $B_{My}$, $B_{Mx}$ und/oder eine erste, zweite und dritte Kalibrierungsfeldkomponente $B_{Kz}$, $B_{Ky}$ und $B_{Kx}$ aufweist. Der Magnetfeldsensor umfasst eine erste Sensorelementanordnung, die wenigstens zwei Sensorelemente aufweist, zur Erfassung der ersten Magnetfeldkomponente $B_z$, die eine erste Messfeldkomponente $B_{Mz}$ und/oder eine erste Kalibrierungsfeldkomponente $B_{Kz}$ aufweist, bezüglich einer ersten Raumachse z im Referenzpunkt.

Ferner umfasst der Magnetfeldsensor eine zweite Sensorelementanordnung, die wenigstens zwei Sensorelemente aufweist, zur Erfassung der zweiten Magnetfeldkomponente $B_y$, die eine zweite Messfeldkomponente $B_{My}$ und/oder eine zweite Kalibrierungsfeldkomponente $B_{Ky}$ aufweist, bezüglich einer zweiten Raumachse y im Referenzpunkt. Der Magnetfeldsensor umfasst ferner eine dritte Sensorelementanordnung, die wenigstens zwei Sensorelemente aufweist, zur Erfassung der dritten Magnetfeldkomponente $B_x$, die eine dritte Messfeldkomponente $B_{Mx}$ und/oder eine dritte Kalibrierungsfeldkomponente $B_{Kx}$ aufweist, bezüglich einer dritten Raumachse x im Referenzpunkt. Der Magnetfeldsensor weist ferner eine Erregerleitung auf, die so bezüglich der ersten, zweiten und dritten Sensorelementanordnung angeordnet ist, dass bei einer Einprägung eines vorgegebenen Stroms $I_{kl}$ in die Erregerleitung ein erstes Paar von unterschiedlichen vorgegebenen Kalibrierungsfeldkomponenten $B_{Kza}$ und $B_{Kzb}$ bezüglich der ersten Raumachse z in der ersten Sensorelementanordnung erzeugt wird, ein zweites Paar von unterschiedlichen vorgegebenen Kalibrierungsfeldkomponenten $B_{Kya}$ und $B_{Kyb}$ bezüglich der zweiten Raumachse y in der zweiten Sensorelementanordnung erzeugt wird und ein drittes Paar von unterschiedlichen vorgegebenen Kalibrierungsfeldkomponenten $B_{Kxa}$ und $B_{Kxb}$ bezüglich der dritten Raumachse x in der dritten Sensorelementanordnung erzeugt wird, wobei die drei Raumachsen z, y und x entlang linear unabhängiger Ortsvektoren verlaufen.

Der vorliegenden Erfindung liegt die Erkenntnis zugrunde, dass vorzugsweise paarweise symmetrisch angeordnete Sensorelemente, einen Magnetfeldsensor zur mehrdimensionalen Erfassung eines Magnetfeldes schaffen können, der mit Hilfe zumindest einer asymmetrischen Erregerleitung kalibrierbar wird. Die Erregerleitung ist dabei bezüglich der paarweise angeordneten Sensorelemente insofern asymmetrisch, als dass das durch Bestromung mit der Erregerleitung erzeugbare Magnetfeld ungleiche Kalibrierfeldkomponenten in den paarweisen Sensorelementen hervorruft. Dabei können auch Sensorelemente gleicher Empfindlichkeit eingesetzt werden, denn durch die erwähnte Asymmetrie ergeben sich unterschiedliche Kalibrierfeldkomponenten, deren Differenz messbar ist und mit deren Hilfe der Magnetfeldsensor kalibrierbar ist. Mit Hilfe von Ausführungsbeispielen von erfindungsgemäßen Magnetfeldsensoren lassen sich so zweidimensionale und auch dreidimensionale Magnetfelder entlang zweier bzw. dreier linear unabhängiger Ortsvektoren erfassen.

Es können auch mehrere Erregerleitungen eingesetzt werden, die bezüglich der paarweisen Sensorelemente unterschiedliche oder auch gespiegelte bzw. entgegengesetzte Asymmetrien aufweisen können. Beispielsweise können die Erregerleitungen Spulen bilden, deren Magnetfelder sich überlagern und so ein resultierendes Erregerfeld in einer Empfindlichkeitsrichtung eines Sensorelementes hervorrufen. Dies wirkt sich vorteilhaft aus, da der Magnetfeldsensor so im Messbetrieb kalibrierbar und überprüfbar ausgebildet werden kann.

Ein weiterer Vorteil des erfindungsgemäßen Magnetfeldsensors und Verfahrens liegt darin, dass der Magnetfeldsensor im Betrieb kalibriert werden kann und dabei zusätzlicher Hardware- oder Zeitaufwand eingespart werden kann. Beispielsweise können die Messergebnisse von einem Mikrocontroller oder einem Prozessor kombiniert bzw. ausgewertet werden, so dass ein zusätzlicher Aufwand auf nur eine zusätzliche Rechenoperation beschränkt wird. Die Messfeldkomponenten und die Kalibrierungsfeldkomponenten können dabei jeweils gleichzeitig und kompensiert zur Verfügung gestellt werden. Dies ist gerade bei sicherheitskritischen Anwendungsfällen, wie beispielsweise in der Automobil- oder Medizintechnik äußerst vorteilhaft, da der Magnetfeldsensor kontinuierlich kalibriert bzw. justiert und gleichzeitig seine Funktionsfähigkeit überwacht werden kann, ohne dass dabei in vielen Fällen Kompromisse hinsichtlich der Qualität oder Quantität einer Messung eingegangen werden müssen. Bevorzugte Ausführungsbeispiele der Erfindung werden nachfolgend unter Bezugnahme auf die beiliegenden Zeichnungen näher erläutert. Es zeigen:

Fig. 1a      eine prinzipielle Anordnung von Hall- Sensorelementen und einer Erregerleitung gemäß einem Ausführungsbeispiel des im Messbetrieb ka- librierbaren Magnetfeldsensors zur Erfassung ei- ner ersten und einer zweiten räumlichen Magnet- feldkomponente gemäß der vorliegenden Erfindung;

Fig. 1b      eine weitere prinzipielle Anordnung von Hall- Sensorelementen und einer Erregerleitung gemäß einem Ausführungsbeispiel des im Messbetrieb ka- librierbaren Magnetfeldsensors zur Erfassung ei- ner ersten und einer zweiten räumlichen Magnet- feldkomponente gemäß der vorliegenden Erfindung;

Fig. 1c     eine prinzipielle Anordnung von Hall- Sensorelementen und einer Erregerleitung gemäß einem Ausführungsbeispiel des im Messbetrieb ka- librierbaren Magnetfeldsensors zur Erfassung ei- ner ersten, einer zweiten und einer dritten räum- lichen Magnetfeldkomponente gemäß der vorliegen- den Erfindung;

Fig. 1d     eine weitere prinzipielle Anordnung von Hall- Sensorelementen und einer Erregerleitung gemäß einem Ausführungsbeispiel des im Messbetrieb ka- librierbaren Magnetfeldsensors zur Erfassung ei- ner ersten, einer zweiten und einer dritten räum- lichen Magnetfeldkomponente gemäß der vorliegen- den Erfindung;

Fig. 2     eine prinzipielle Anordnung von Hall- Sensorelementen und einer Erregerleitung gemäß einem weiteren Ausführungsbeispiel des im Messbe- trieb kalibrierbaren Magnetfeldsensors gemäß der vorliegenden Erfindung;

Fig. 3a     eine prinzipielle Anordnung von Hall- Sensorelementen und einer Erregerleitung gemäß einem weiteren Ausführungsbeispiel des im Messbe- trieb kalibrierbaren Magnetfeldsensors gemäß der vorliegenden Erfindung;

Fig. 3b     eine prinzipielle Anordnung von Hall- Sensorelementen und einer Erregerleitung gemäß einem weiteren Ausführungsbeispiel des im Messbe- trieb kalibrierbaren Magnetfeldsensors gemäß der vorliegenden Erfindung;

Fig. 4     ein weiteres Ausführungsbeispiel eines Magnet- feldsensors;

Fig. 5     ein weiteres Ausführungsbeispiel eines Magnet- feldsensors;

Fig. 6a     den prinzipiellen Aufbau eines horizontalen Hall- Sensorelementes gemäß dem Stand der Technik;

Fig. 6b     den prinzipiellen Aufbau eines vertikalen Hall- Sensorelementes gemäß dem Stand der Technik;

Fig. 7     prinzipielle Anordnung von Einzelsensoren zur räumlichen Erfassung von Magnetfeldkomponenten gemäß dem Stand der Technik;

Fig. 8     alternativer 3D-Sensor zur Erfassung räumlicher Komponenten eines Magnetfeldes gemäß dem Stand der Technik; und

Fig. 9     prinzipielle Anordnung von Einzel-Hall- Sensorelementen zur Erfassung eines räumlichen Magnetfeldes in einem Punkt.

Bezüglich der nachfolgenden Ausführungen sollte beachtet werden, dass in den unterschiedlichen Ausführungsbeispielen gleiche oder gleichwirkende Funktionselemente gleiche Bezugszeichen aufweisen und somit in den verschiedenen, in den nachfolgend dargestellten Ausführungsbeispielen untereinander austauschbar sind.

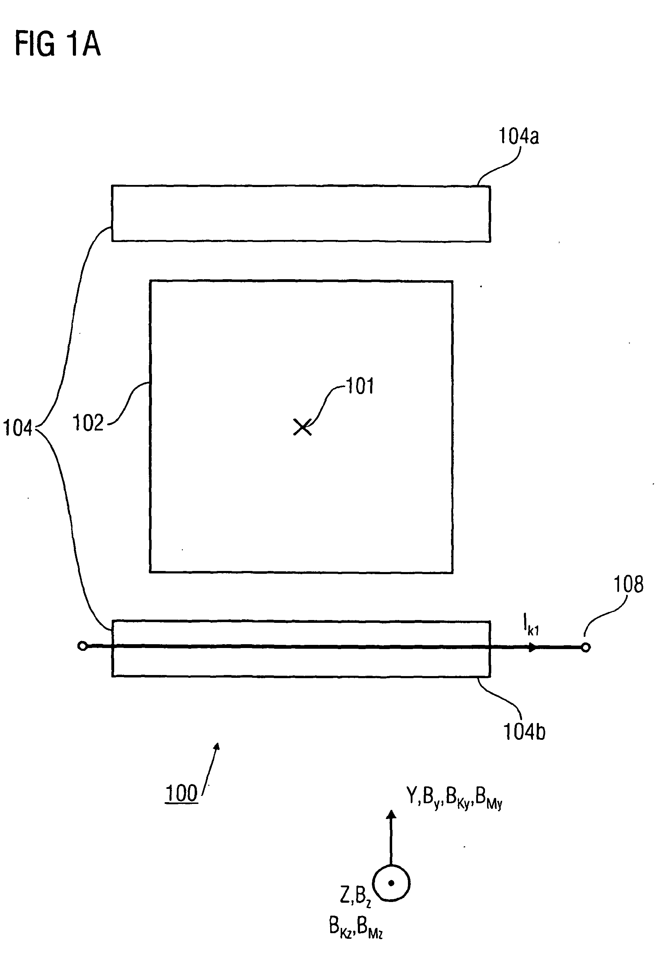

Die Fig. 1a zeigt einen kalibrierbaren Magnetfeldsensor 100 zur Erfassung einer ersten und einer zweiten räumlichen Komponente ($B_y$, $B_z$) eines Magnetfeldes in einem Referenzpunkt 101, wobei das Magnetfeld eine erste und eine zweite Messfeldkomponente ($B_{My}$, $B_{Mz}$) und/oder eine erste und eine zweite Kalibrierungsfeldkomponente ($B_{Ky}$, $B_{Kz}$) aufweist. Der Magnetfeldsensor 100 umfasst eine erste Sensorelementanordnung 104, die wenigstens ein erstes und ein zweites Sensorelement (104a, 104b) aufweist, zur Erfassung der ersten Magnetfeldkomponente $B_y$, die eine erste Messfeldkomponente $B_{My}$ und/oder eine erste Kalibrierungsfeldkomponente $B_{Ky}$ aufweist, bezüglich einer ersten Raumachse y im Referenzpunkt 101.

Ferner umfasst der Magnetfeldsensor 100 eine zweite Sensorelementanordnung 102 zur Erfassung der zweiten Magnetfeldkomponente $B_z$, die eine zweite Messfeldkomponente $B_{Mz}$ und/oder eine zweite Kalibrierungsfeldkomponente $B_{Kz}$ aufweist, bezüglich einer zweiten Raumachse z im Referenzpunkt 101. Der Magnetfeldsensor 100 umfasst ferner eine Erregerleitung 108, die so bezüglich der ersten Sensorelementanordnung 104 angeordnet ist, das bei einer Einprägung eines vorgegebenen Stromes $I_{k1}$ in die Erregerleitung 108 ein Paar von unterschiedlichen vorgegebenen Kalibrierungsfeldkomponenten $B_{Kya}$ in dem ersten Sensorelement 104a und $B_{Kyb}$ in dem zweiten Sensorelement 104b bezüglich der ersten Raumachse y in der ersten Sensorelementanordnung 104 erzeugt wird, wobei die zwei Raumachsen y und z entlang linear unabhängiger Ortsvektoren verlaufen.

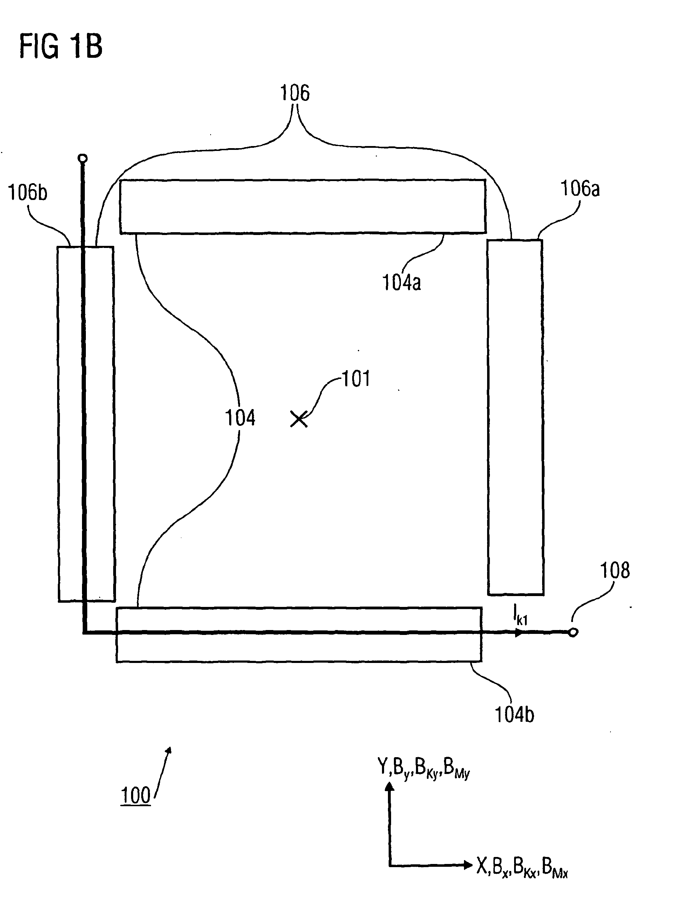

Die Fig. 1b zeigt ein weiteres Ausführungsbeispiel eines kalibrierbaren Magnetfeldsensors 100 zur Erfassung einer ersten und einer zweiten räumlichen Komponente ($B_x$, $B_y$) eines Magnetfeldes in einem Referenzpunkt 101, wobei das Magnetfeld eine erste und eine zweite Messfeldkomponente ($B_{Mx}$, $B_{My}$) und/oder eine und eine zweite Kalibrierungsfeldkomponente ($B_{Kx}$, $B_{Ky}$) aufweist. Der Magnetfeldsensor 100 umfasst eine erste Sensorelementanordnung 106, die wenigstens ein erstes und ein zweites Sensorelement 106a und 106b aufweist, zur Erfassung der ersten Magnetfeldkomponente $B_x$, die eine erste Messfeldkomponente $B_{Mx}$ und/oder eine erste Kalibrierungsfeldkomponente $B_{Kx}$

aufweist, bezüglich der ersten Raumachse x im Referenzpunkt 101.

Der Magnetfeldsensor, der in der Fig. 1b dargestellt ist, umfasst ferner eine zweite Sensorelementanordnung 104 zur Erfassung der zweiten Magnetfeldkomponente $B_y$, die eine zweite Messfeldkomponente $B_{My}$ und/oder eine zweite Kalibrierungsfeldkomponente $B_{Ky}$ aufweist, bezüglich einer zweiten Raumachse y im Referenzpunkt 101.

Im Ausführungsbeispiel der Fig. 1b umfasst der Magnetfeldsensor 100 ferner eine Erregerleitung 108, die so bezüglich der ersten Sensorelementanordnung 106 angeordnet ist, dass bei einer Einprägung eines vorgegebenen Stromes $I_{K1}$ in der Erregerleitung 108 ein Paar von unterschiedlichen vorgegebenen Kalibrierungsfeldkomponenten $B_{Kxa}$ in dem ersten Sensorelement 106a und $B_{Kxb}$ in dem zweiten Sensorelement 106b bezüglich der ersten Raumachse x in der ersten Sensorelementanordnung 106 erzeugt wird, wobei die zwei Raumachsen x und y entlang unabhängiger Ortsvektoren verlaufen. In einem weiteren Ausführungsbeispiel können die Sensorelemente so angeordnet sein, dass sie sich auf die zwei Raumachsen x und z beziehen, wobei in einem solchen Ausführungsbeispiel die erste Sensorelementanordnung der Sensorelementanordnung 106 aus der Fig. 1b entspräche, und die zweite Sensorelementanordnung der Sensorelementanordnung 102 aus der Fig. 1a entspräche. Im allgemeinen Fall können erfindungsgemäße Ausführungsbeispiele Magnetfelder gemäß zweier entlang linear unabhängigen Ortsvektoren verlaufender Raumrichtungen erfassen, wobei die Erregerleitung 108 dabei so angeordnet ist, dass sie zumindest bezüglich einer Sensorelementanordnung des Magnetfeldsensors, die wenigstens zwei Sensorelemente aufweist, unterschiedliche Kalibrierfeldkomponenten erzeugen kann. Dabei sind die Richtungen der linear unabhängigen Ortsvektoren nicht festgelegt, so dass zwei beliebige Raumrichtungen realisierbar sind.

Gemäß dem Ausführungsbeispiel, dass in der Fig. 1b dargestellt ist, kann der kalibrierbare Magnetfeldsensor 100 eine zweite Sensorelementanordnung 104 umfassen, die ebenfalls wenigstens ein erstes 104a und ein zweites Sensorelement 104b aufweist und die Erregerleitung ferner so bezüglich der zweiten Sensorelementanordnung 104 angeordnet ist, dass ein zweites Paar von unterschiedlichen vorgegebenen Kalibrierungsfeldkomponenten $B_{kya}$ in dem ersten Sensorelement 104a und $B_{Kyb}$ in dem zweiten Sensorelement 104b bezüglich der zweiten Raumachse y in der zweiten Sensorelementanordnung 104 erzeugt wird.

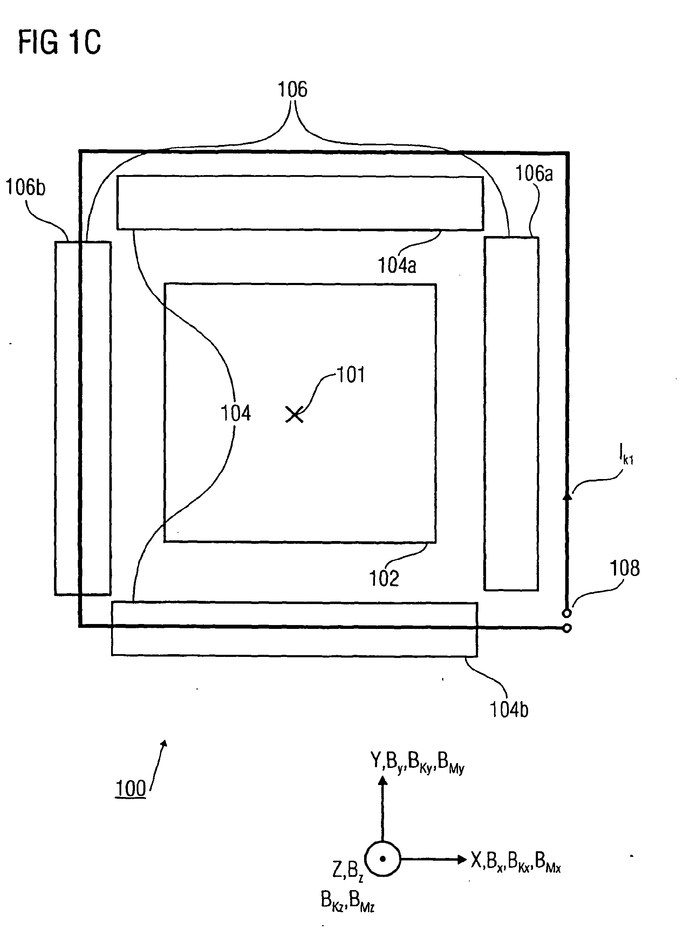

Neben den anhand der Fign. 1a und 1b beschriebenen Magnetfeldsensoren zur Erfassung von wenigstens zwei räumlichen Dimensionen können in Ausführungsbeispielen auch drei Raumrichtungen erfasst werden. Die Fig. 1c zeigt ein Ausführungsbeispiel eines kalibrierbaren Magnetfeldsensors 100, der ferner ausgebildet ist, um eine dritte räumliche Komponente $B_x$ oder $B_z$ des Magnetfeldes in dem Referenzpunkt 100 zu erfassen, wobei das Magnetfeld eine dritte Messfeldkomponente $B_{Mx}$ oder $B_{Mz}$ und/oder eine dritte Kalibrierungsfeldkomponente $B_{Kx}$ oder $B_{Kz}$ aufweist.

Bezüglich der Fig. 1a wird von dem Ausführungsbeispiel des Magnetfeldsensors, welcher in der Fig. 1c dargestellt ist, zusätzlich eine magnetische Raumkomponente $B_x$ erfasst, im Bezug auf die Fig. 1b erfasst das Ausführungsbeispiel des Magnetfeldsensors der Fig. 1c zusätzlich die magnetische Raumkomponente $B_z$.

Das Ausführungsbeispiel des Magnetfeldsensors 100 der Fig. 1c umfasst ferner eine dritte Sensorelementanordnung 106 oder 102, zur Erfassung der dritten Magnetfeldkomponente $B_x$ oder $B_z$, die die dritte Messfeldkomponente $B_{Mx}$ oder $B_{Mz}$ und/oder die dritte Kalibrierungsfeldkomponente $B_{Kx}$ oder $B_{Kz}$ aufweist, bezüglich einer dritten Raumachse x oder z im Referenzpunkt 101, wobei die drei Raumachsen z, y und x entlang linear unabhängiger Ortsvektoren verlaufen.

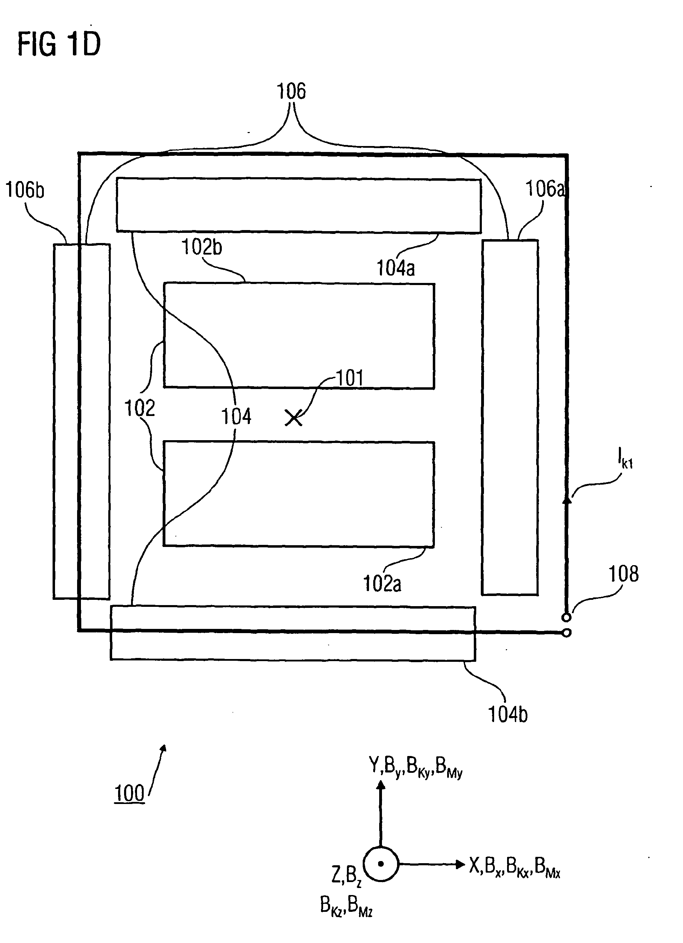

Ein weiteres Ausführungsbeispiel eines Magnetfeldsensors 100 ist in der Fig. 1d gezeigt. In dem Ausführungsbeispiel der Fig. 1d umfasst die dritte Sensorelementanordnung 102 ebenfalls ein erstes und ein zweites Sensorelement 102a und 102b, wobei die Erregerleitung 108 so bezüglich der dritten Sensorelementanordnung 102 angeordnet ist, dass bei einer Einprägung eines vorgegeben Stroms $I_{k1}$ in die Erregerleitung 108 ein Paar von unterschiedlichen vorgegebenen Kalibrierungsfeldkomponenten $B_{Kza}$ und $B_{Kzb}$ in dem ersten Sensorelement 102a und in dem zweiten Sensorelement 102b bezüglich der dritten Raumachse z in der dritten Sensorelementanordnung erzeugt wird.

Generell umfassen Ausführungsbeispiele kalibrierbare Magnetfeldsensoren zur Erfassung zweier oder dreier räumlicher Magnetfeldkomponenten. Die Fign. 1a bis 1d zeigen dabei verschiedene Varianten, wobei die einzelnen Raumrichtungen dabei austauschbar sind. So kann beispielsweise einem Magnetfeldsensor gemäß der Fig. 1a eine dritte Sensorelementanordnung 106 gemäß der Fig. 1c zugefügt werden.

Im Folgenden werden Ausführungsbeispiele der vorliegenden Erfindung im Detail erläutert. Um Wiederholungen zu vermeiden, wird in den folgenden Ausführungsbeispielen davon ausgegangen, dass die jeweiligen Magnetfeldsensoren ein Magnetfeld nach drei Raumrichtungen erfassen, wobei die drei Raumrichtungen entlang linear unabhängiger Ortsvektoren verlaufen. Generell sind aber alle im Folgenden beschriebenen Ausführungsbeispiele auch zur Erfassung lediglich zweier Raumrichtungen von Magnetfeldern denkbar. Deswegen kann bei den im Folgenden erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die nachfolgenden Ausführungen bezüglich der Sensorelemente und deren Weiterbildungen jeweils gleichermaßen auch auf die Ausführungsbeispiele der Fign. 1a und 1b anwendbar.

Die Fig. 1d zeigt ein Ausführungsbeispiel eines im Messbetrieb kalibrierbaren Magnetfeldsensors 100 zur Erfassung einer ersten, zweiten und dritten räumlichen Komponente $B_z$, $B_y$ und $B_x$ eines Magnetfeldes in einem Referenzpunkt 101, wobei das Magnetfeld eine erste, zweite und dritte Messfeldkomponente $B_{Mz}$, $B_{My}$, $B_{Mx}$ und/oder eine erste, zweite und dritte Kalibrierungsfeldkomponente $B_{Kz}$, $B_{Ky}$ und $B_{Kx}$ aufweist.

Der Magnetfeldsensor 100 umfasst eine erste Sensorelementanordnung 102, die wenigstens zwei Sensorelemente 102a und 102b aufweist, zur Erfassung der ersten Magnetfeldkomponente $B_z$, die eine erste Messfeldkomponente $B_{Mz}$ und/oder eine erste Kalibrierungsfeldkomponente $B_{Kz}$ aufweist, bezüglich einer ersten Raumachse z im Referenzpunkt 101. Der Magnetfeldsensor 100 umfasst ferner eine zweite Sensorelementanordnung 104, die wenigstens zwei Sensorelemente 104a und 104b aufweist, zur Erfassung der zweiten Magnetfeldkomponente $B_y$, die eine zweite Messfeldkomponente $B_{My}$ und/oder eine zweite Kalibrierungsfeldkomponente $B_{Ky}$ aufweist, bezüglich einer zweiten Raumachse y im Referenzpunkt 101. Der Magnetfeldsensor 100 umfasst auch eine dritte Sensorelementanordnung 106, die wenigstens zwei Sensorelemente 106a und 106b aufweist, zur Erfassung der dritten Magnetfeldkomponente $B_x$, die eine dritte Messfeldkomponente $B_{Mx}$ und/oder eine dritte Kalibrierungsfeldkomponente $B_{Kx}$ aufweist, bezüglich einer dritten Raumachse x im Referenzpunkt 101.

Der Magnetfeldsensor 100 umfasst ferner eine Erregerleitung 108, die so bezüglich der ersten 102, zweiten 104 und dritten Sensorelementanordnung 106 angeordnet ist, dass bei einer Einprägung eines vorgegebenen Stroms $I_{k1}$ in die Erregerleitung 108 ein erstes Paar von unterschiedlichen vorgegebenen Kalibrierungsfeldkomponenten $B_{Kza}$ in dem Sensorelement 102a und $B_{Kzb}$ in dem Sensorelement 102b bezüglich der ersten Raumachse z in der ersten Sensorelementanordnung 102 erzeugt wird, ein zweites Paar von unterschiedlichen vorgegebenen Kalibrierungsfeldkomponenten $B_{Kya}$ in dem Sensorelement 104a und $B_{Kyb}$ in dem Sensorelement 104b bezüglich der zweiten Raumachse y in der zweiten Sensorelementanordnung 104 erzeugt wird und ein drittes Paar von unterschiedlichen vorgegebenen Kalibrierungsfeldkomponenten $B_{Kxa}$ in dem Sensorelement 106a und $B_{Kxb}$ in dem Sensorelement 106b bezüglich der dritten Raumachse x in der dritten Sensorelementanordnung 106 erzeugt wird, wobei die drei Raumachsen z, y und x entlang linear unabhängiger Ortsvektoren verlaufen.

Die Fig. 1d zeigt ein Ausführungsbeispiel eines Magnetfeldsensors 100, der eine asymmetrisch angeordnete Erregerleitung 108 aufweist. Die Paare von unterschiedlich vorgegebenen Kalibrierungsfeldkomponenten bezüglich der je wenigstens zwei Sensorelemente (z.B. 102a, 102b; 104a, 104b; 106a, 106b) einer Sensorelementanordnung (z.B. 102, 104, 106) werden dabei durch die Asymmetrie der Erregerleitung bezüglich des Referenzpunktes 101 erreicht. Die Erregerleitung 108 kann dabei gemäß dem Ausführungsbeispiel der Fig. 1d derart angeordnet sein, dass sie eine Spule mit zumindest einer Windung bildet.

Geometrisch betrachtet kann die Erregerleitung 108 in Ausführungsbeispielen derart angeordnet sein, dass die Spule mit der zumindest einen Windung, kürzeste Abstände zu den wenigstens zwei Sensorelementen (z.B. 102a, 102b; 104a, 104b; 106a, 106b) einer Sensorelementanordnung (z.B. 102, 104, 106) aufweist, die unterschiedlich sind. Durch kürzere Abstände der Erregerleitung 108 zu den Sensorelementanordnungen (z.B. 104, 106) werden bei Bestromung des Erregerleiters 108 stärkere Kalibrierfeldkomponenten erzeugt als bei größeren Abständen. Ein kürzester Abstand der Erregerleitung 108 zu einem Sensorelement (z.B. 104a, 104b, 106a, 106b) kann sich dabei auf einen mittleren wirksamen Abstand beziehen.

Beispielsweise können dabei die Sensorelemente (z.B. 104a, 104b, 106a, 106b) vorzugsweise paarweise symmetrisch, am Beispiel der Fig. 1d die Sensorelemente 104a und 106a, bzw. 104b und 106b, zu der Erregerleitung 108 ausgeführt sein. Allgemein können jedoch auch beliebige "unsymmetrische" Geometrien realisiert werden, bei denen eine definierte Unsymmetrie bezüglich der Kalibrierfeldkomponenten in den verschiedenen Sensorelementen (z.B. 104a, 104b, 106a, 106b) oder Sensorelementanordnungen (z.B. 104, 106) erzeugt wird. Die Unsymmetrie kann auch über unterschiedlich starke Erregerströme erfolgen. Die paarweise symmetrische Anordnung erlaubt eine einfache Auswertung, wohingegen zwischen den Sensorelementen (z.B. 104a und 104b, bzw. 106a und 106b) durch unterschiedliche Abstände eine definierte Unsymmetrie und demzufolge auch eine definierte Unsymmetrie bezüglich der erzeugbaren Kalibrierfeldkomponenten vorhanden sein kann. Dies kann beispielsweise gemäß der Fign. 1a bis 1d durch eine geometrische Verschiebung oder eine Asymmetrie der Erregerleitung 108 hinsichtlich des Referenzpunktes 101 erreicht werden. Die Erregerleitung 108 verläuft in den Ausführungsbeispielen der Fign. 1c und 1d direkt oberhalb der Sensorelemente 104b und 106b, allerdings seitlich der Sensorelemente 104a und 106a. Insofern sind die unterschiedlichen kürzesten Abstände der Erregerleitung 108 zu den Sensorelementen (z.B. 104a, 104b; 106a, 106b) einer Sensorelementanordnung (z.B. 104, 106) so zu verstehen, dass die Erregerleitung 108 zu je zwei Sensorelementen (z.B. 104a und 104b, bzw. 106a und 106b) einer Sensorelementanordnung (z.B. 104 bzw. 106) unterschiedliche Abstände aufweist, so dass die magnetischen Feldkomponenten, die in den Sensorelementen (z.B. 104a und 104b, bzw. 106a und 106b) einer Sensorelementanordnung (z.B. 104 bzw. 106) aufgrund eines Stromes $I_{k1}$ in der Erregerleitung 108 hervorgerufen werden ebenfalls unterschiedlich sind.

Wie bereits oben erläutert kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

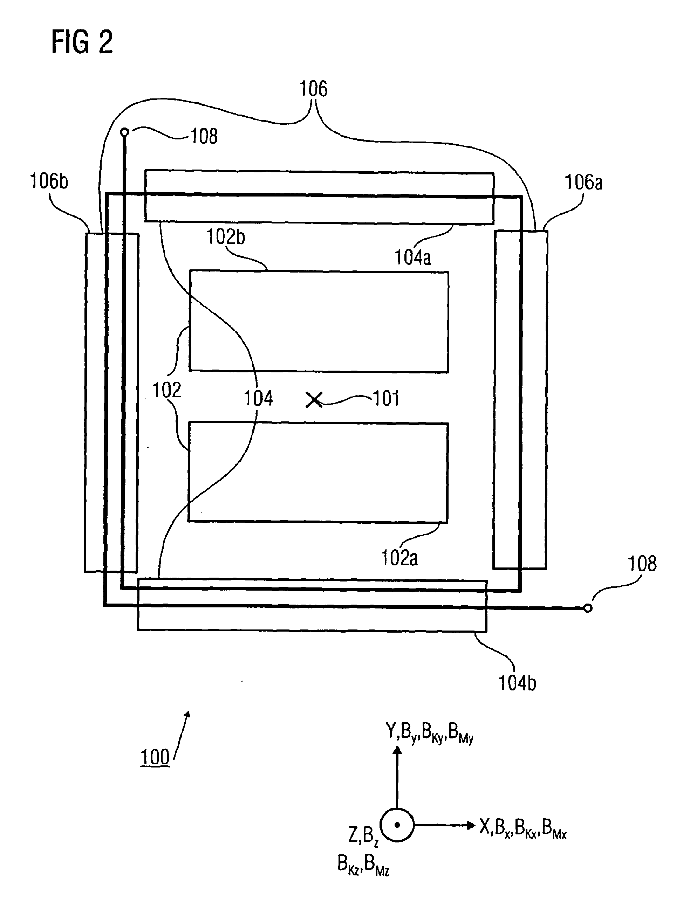

In anderen Ausführungsbeispielen kann die Erregerleitung 108 bezüglich des Referenzpunktes 101 auch symmetrisch angeordnet sein. Ein solches Ausführungsbeispiel ist in der Fig. 2 illustriert. Die Fig. 2 zeigt ein weiteres Ausführungsbeispiel eines Magnetfeldsensors 100, das die gleichen Komponenten aufweist, die bereits anhand der Fig. 1d dargestellt und erläutert wurden. Der Unterschied zu der Fig. 1d besteht nun in der Anordnung der Erregerleitung 108, die in der Fig. 2 als eine Spule mit 1,5 Windungen ausgeprägt ist. Generell sind in Ausführungsbeispielen Spulenausprägungen beliebiger Windungszahl denkbar, die bereits erwähnte Asymmetrie kann jedoch auch durch nicht vollständige Windungen bzw. Teilwindungen erreicht werden, wie es schematisch in der Fig. 2 dargestellt ist. Generell wäre hier auch eine einzelne Teilwindung, vgl. Fign. 1a und 1b, denkbar. In diesen Fällen kann also eine Teilwindung auch durch eine Leiterbahn gemäß der Fign. 1a und 1b realisiert werden, die bezüglich der Sensorelemente einer Sensorelementanordnung asymmetrisch angeordnet ist.

Ausführungsbeispiele können auch Erregerleitungen 108 aufweisen, die nicht symmetrisch bezüglich des Referenzpunktes 101 ausgebildet sind und eine nicht-ganzzahlige Windungszahl aufweisen. Demnach kann die Erregerleitung 108 derart ausgebildet sein, dass sie eine volle Windung und eine Teilwindung aufweist. Auch hier ist eine paarweise symmetrische Anordnung der Erregerleitung 108 bezüglich der Sensorelemente (z.B. 104a, 104b, 106a, 106b) denkbar, wobei der allgemeine Fall nicht auf diese Symmetrie beschränkt ist und in Ausführungsbeispielen beliebige Anordnungen vorkommen können, die definierte "unsymmetrische" Kalibrierfeldkomponenten erzeugen können.

Wie bereits oben erläutert kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen, zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

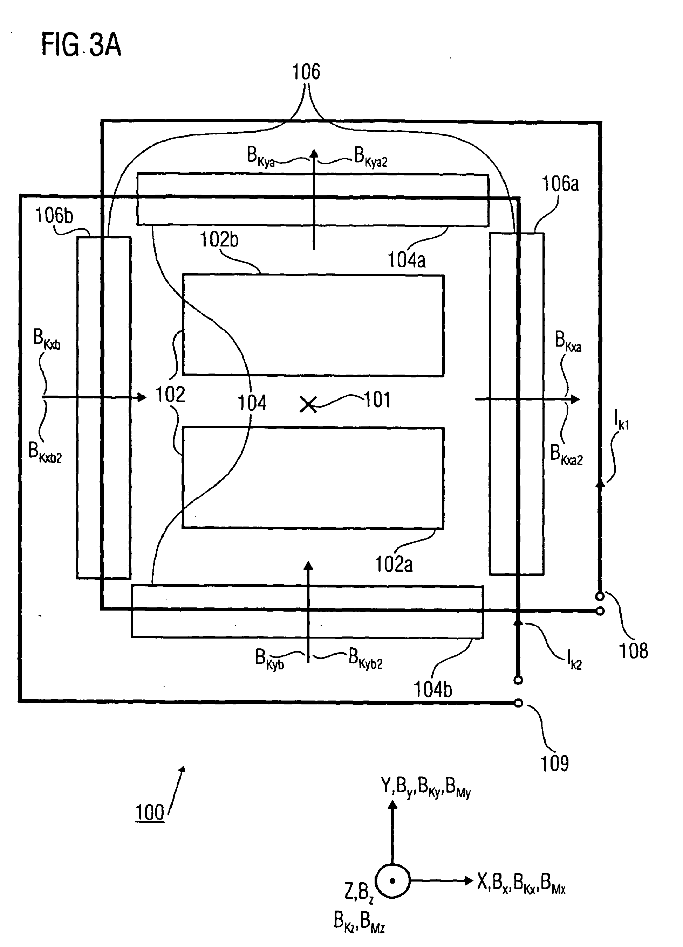

Ein weiteres Ausführungsbeispiel eines Magnetfeldsensors 100 ist in der Fig. 3a dargestellt. Der Magnetfeldsensor 100 der Fig. 3a weist die gleichen Komponenten auf wie die, die anhand der Fign. 1a-d und 2 dargestellt und erläutert wurden. Zusätzlich ist in dem Ausführungsbeispiel der Fig. 3a eine zweite Erregerleitung 109 vorhanden. Gemäß der Fig. 3a ist die zweite Erregerleitung 109 bezüglich der Erregerleitung 108 verschoben, d.h. die Erregerleitung 108 verläuft direkt oberhalb der Sensorelemente 104b und 106b, allerdings seitlich der Sensorelemente 104a und 106a. Die zweite Erregerleitung 109 verläuft direkt oberhalb der Sensorelemente 104a und 106a, allerdings seitlich der Sensorelemente 104b und 106b.

Auch hier kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

In Ausführungsbeispielen kann die zweite Erregerleitung 109 so bezüglich der ersten 102, zweiten 104 und dritten Sensorelementanordnung 106 angeordnet sein, dass bei einer Einprägung eines weiteren vorgegebenen Stroms $I_{k2}$ in die zweite Erregerleitung 109 ein erstes weiteres Paar von unterschiedlichen vorgegebenen Kalibrierungsfeldkomponenten $B_{Kza2}$ in dem Sensorelement 102a und $B_{Kzb2}$ in dem Sensorelement 102b bezüglich der ersten Raumachse z in der ersten Sensorelementanordnung 102 erzeugt wird, ein zweites weiteres Paar von unterschiedlichen vorgegebenen Kalibrierungsfeldkomponenten $B_{Kya2}$ in dem Sensorelement 104a und $B_{Kyb2}$ in dem Sensorelement 104b bezüglich der zweiten Raumachse y in der zweiten Sensorelementanordnung 104 erzeugt wird und ein drittes weiteres Paar von unterschiedlichen vorgegebenen Kalibrierungsfeldkomponenten $B_{Kxa2}$ in dem Sensorelement 106a und $B_{Kxb2}$ in dem Sensorelement 106b bezüglich der dritten Raumachse x in der dritten Sensorelementanordnung 106 erzeugt wird.

Gemäß der Fig. 3a können über die zweite Erregerleitung also zusätzliche Kalibrierungsfeldkomponenten erzeugt werden. Auch hier ist eine paarweise symmetrische Anordnung der zweiten Erregerleitung 109 bezüglich der Sensorelemente (z.B. 104a, 104b, 106a, 106b) denkbar, wobei der allgemeine Fall nicht auf diese Symmetrie beschränkt ist und in Ausführungsbeispielen beliebige Anordnungen vorkommen können, die definierte Kalibrierfeldkomponenten erzeugen können.

Dabei können in Ausführungsbeispielen die erste Erregerleitung 108 und die zweite Erregerleitung 109 derart angeordnet sein, dass das erste weitere Paar von unterschiedlichen vorgegebenen Kalibrierungsfeldkomponenten in einer umgekehrten Relation zueinander steht als das erste Paar von Kalibrierungsfeldkomponenten, dass das zweite weitere Paar von unterschiedlichen vorgegebenen Kalibrierungsfeldkomponenten in einer umgekehrten Relation zueinander steht als das zweite Paar von Kalibrierungsfeldkomponenten und dass das dritte weitere Paar von unterschiedlichen vorgegebenen Kalibrierungsfeldkomponenten in einer umgekehrten Relation zueinander steht als das dritte Paar von Kalibrierungsfeldkomponenten. Die ist in der Fig. 3a beispielhaft durch die Geometrie der ersten 108 und zweiten Erregerleitung 109 untereinander dargestellt.

Als Beispiel sei die erste Erregerleitung 108 bestromt während die zweite Erregerleitung keinen Strom führt. Demnach erzeugt die erste Erregerleitung 108 in den Sensorelementen 104b und 106b starke Kalibrierungsfeldkomponenten $B_{Kyb}$ und $B_{Kxb}$, in den Sensorelementen. 104a und 106a schwache Kalibrierungsfeldkomponenten $B_{Kya}$ und

$B_{Kxa}$. Wird die Betromung nun umgekehrt, sodass die erste Erregerleitung 108 stromlos wird und die zweite Erregerleitung den Strom $I_{k2}$ führt, der zuvor in der ersten Erregerleitung geflossen ist, dann erzeugt die zweite Erregerleitung 108 in den Sensorelementen 104b und 106b schwache Kalibrierungsfeldkomponenten $B_{Kyb2}$ und $B_{Kxb2}$, in den Sensorelementen 104a und 106a starke Kalibrierungsfeldkomponenten $B_{Kya2}$ und $B_{Kxa2}$. In Ausführungsbeispielen können die Erregerleitungen 108 und 109 so angeordnet sein, dass in einem solchen Beispiel gelten kann

$$B_{Kyb}/B_{Kya} = B_{Kxb}/B_{Kxa} ,$$

$$B_{Kyb2}/B_{Kya2} = B_{Kxb2}/B_{Kxa2},$$

oder

$$B_{Kyb}/B_{Kya} = B_{Kxa2}/B_{Kxb2} .$$

In Ausführungsbeispielen kann die erste Sensorelementanordnung 102 ein bezüglich einer Hauptoberfläche des Magnetfeldsensors horizontales Hall-Sensorelement 102a oder 102b aufweisen. Generell können in Ausführungsbeispielen beliebige Magnetfeldsensoren zum Einsatz kommen, die für die unterschiedlichen Magnetfeldkomponenten ($B_x$, $B_y$, $B_z$) entsprechende Empfindlichkeiten aufweisen. Beispielsweise ist auch der Einsatz von magnetoresistiven Sensorelementen denkbar. Im Folgenden werden Ausführungsbeispiele der vorliegenden Erfindung beispielhaft durch Realisierungen mit Hall-Sensorelementen beschrieben. Die erste Sensorelementanordnung 102 kann ferner eine Mehrzahl von bezüglich einer Hauptoberfläche des Magnetfeldsensors horizontalen Hall-Sensorelementen aufweisen, wobei die geometrische Anordnung der Mehrzahl von horizontalen Hall-Sensorelementen (z.B. 102a;102b) bezüglich des Referenzpunktes 101 paarweise symmetrisch sein kann und die Hall-Sensorelemente derart miteinander gekoppelt sind, dass die Magnetfeldkomponente Offset-kompensiert erfassbar sein kann.

Die zweite Sensorelementanordnung 104 kann in Ausführungsbeispielen zumindest zwei bezüglich einer Hauptoberfläche des Magnetfeldsensors vertikale Hall-Sensorelemente (z.B. 104a;104b) aufweisen, wobei die geometrische Anordnung der mindestens zwei vertikalen Hall-Sensorelemente bezüglich des Referenzpunktes 101 paarweise symmetrisch sein kann, und die Sensorelemente derart miteinander gekoppelt sein können, dass die Magnetfeldkomponente Offset-kompensiert erfassbar wird. Generell können in Ausführungsbeispielen auch hier beliebige Magnetfeldsensoren, die für die unterschiedlichen Magnetfeldkomponenten ($B_x$, $B_y$, $B_z$) entsprechende Empfindlichkeiten aufweisen, zum Einsatz kommen.

In Ausführungsbeispielen kann die dritte Sensorelementanordnung 106 zumindest zwei bezüglich einer Hauptoberfläche des Magnetfeldsensors vertikale Hall-Sensorelemente (z.B. 106a;106b) aufweisen, wobei die geometrische Anordnung der mindestens zwei vertikalen Hall-Sensorelemente bezüglich des Referenzpunktes 101 paarweise symmetrisch sein kann, und die derart miteinander gekoppelt sind, dass die Magnetfeldkomponente Offset-kompensiert erfassbar wird. In weiteren Ausführungsbeispielen kann die erste 102, zweite 104 oder dritte Sensorelementanordnung 106 auch im Spinning-Current-Modus betreibbar sind. Generell können in Ausführungsbeispielen auch hier beliebige Magnetfeldsensoren zum Einsatz kommen.

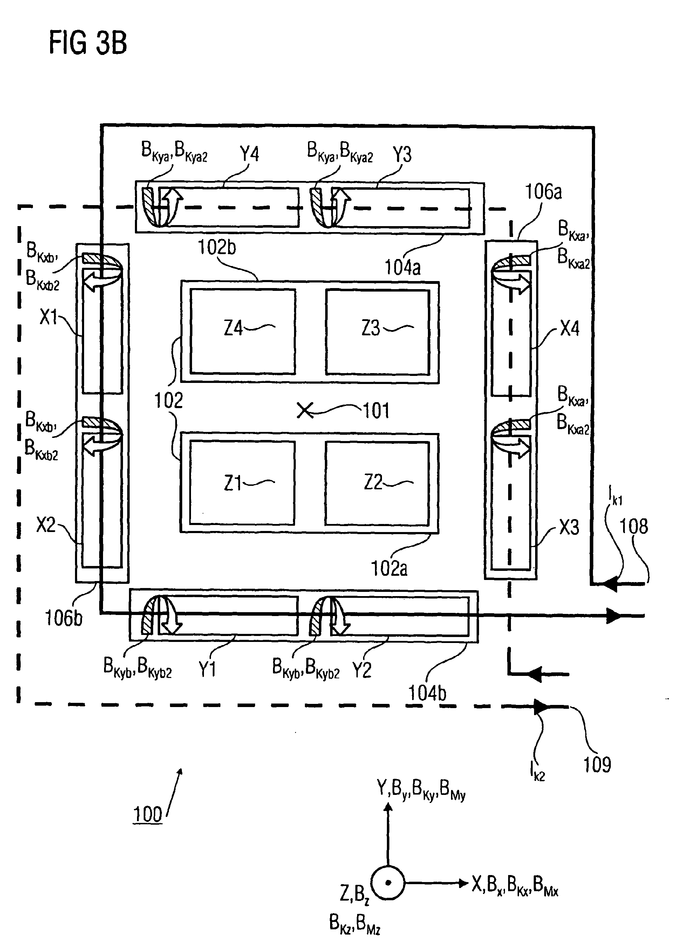

Ein weiteres Ausführungsbeispiel ist in der Fig. 3b dargestellt. Wie bereits oben erläutert kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

Der Magnetfeldsensor 100 der Fig. 3b weist die gleichen Komponenten auf wie die, die anhand der Fign. 1, 2 und 3a dargestellt und erläutert wurden. In dem Ausführungsbeispiel der Fig. 3b ist ebenfalls eine zweite Erregerleitung 109 vorhanden, die als gestrichelte Linie ausgeführt ist. Gemäß der Fig. 3b ist die zweite Erregerleitung 109 bezüglich der Erregerleitung 108 verschoben, d.h. die Erregerleitung 108 verläuft direkt oberhalb der Sensorelemente 104b und 106b, allerdings seitlich der Sensorelemente 104a und 106a. Die zweite Erregerleitung 109 verläuft direkt oberhalb der Sensorelemente 104a und 106a, allerdings seitlich der Sensorelemente 104b und 106b. In der Fig. 3b sind die Sensorelemente (z.B. 102a, 102b, 104a, 104b, 106a, 106b) aus je zwei Einzelsensoren zusammengesetzt, die gemäß ihrer Messausrichtung bezeichnet sind.

Beispielhaft wird in der Fig. 3b davon ausgegangen, dass die Sensorelementanordnung 102 zwei Sensorelemente 102a und 102b umfasst, wobei das Sensorelement 102a zwei Einzelsensoren Z1 und Z2 aufweist und das Sensorelement 102b zwei Einzelsensoren Z3 und Z4 aufweist. Gemäß dem schematisch dargestellten Koordinatenkreuz in der rechten oberen Ecke der Fig. 3b, sei die Sensorelementanordnung 102 derart angeordnet, dass Magnetfeldkomponenten in z-Richtung erfassbar sind. Beispielsweise können die Einzelsensoren Z1-Z4 durch horizontale Hall-Sensoren realisiert sein. In analoger Weise setzt sich in der Fig. 3b die Sensorelementanordnung 104 aus den Sensorelementen 104a und 104b zusammen, die wiederum die Einzelsensoren Y1-Y4 zur Erfassung von Magnetfeldkomponenten in y-Richtung umfassen. Zur Erfassung von Magnetfeldkomponenten in x-Richtung sei die Sensorelementanordnung 106, mit den Sensorelementen 106a und 106b und den Einzelsensoren X1-X4 entsprechend ausgerichtet. Die Einzelsensoren X1-X4 und Y1-Y4 könnten beispielsweise durch vertikale Hall-Sensoren realisiert sein.

In Ausführungsbeispielen können die Magnetfeldsensoren nur mit einer Spule bzw. Erregerleitung 108 erregt werden. Im folgenden wird deshalb die zweite Erregerleitung 109 bzw. Spule zunächst außer Acht gelassen, sie wird in weiteren Ausführungsbeispielen, die später noch betrachtet werden im Detail erläutert. In dem Fall, dass nur eine Erregerleitung 108 bzw. Spule vorhanden ist, kann die Sensorelementanordnung 102, die beispielsweise das Magnetfeld in z-Richtung erfasst, mit einem Magnetfeld erregt werden, das dann nur halb so groß ist, wie z.B. bei Verwendung von zwei Spulen. Bei den Sensorelementanordnungen 104 und 106, die beispielsweise Magnetfelder der x-Richtung und der y-Richtung erfassen, funktioniert die Erregung auf eine andere Weise. Die Sensorelementanordnungen 104 und 106 können aus je vier Teilsensoren, wie es z.B. in der Fig. 3b dargestellt ist, zusammengesetzt sein. In diesem Ausführungsbeispiel erfassen je 2 Teilsensoren das volle Feld der Spule (z.B. X1, X2, Y1, Y2), die jeweils anderen (z.B. X3, X4, Y3, Y4) erfassen nur das deutlich geringere, näherungsweise auch verschwindende, Streufeld, das in die andere Richtung zeigt. Durch eine entsprechende Verschaltung (z.B. Parallelschaltung) der Teilsensoren (z.B. X1-X4, Y1-Y4) ergibt sich jedoch eine Mittelung der Ausgangssignale der Teilsensoren. Zwei Teilsensoren zeigen dann in diesem Ausführungsbeispiel jeweils das volle Signal (z.B. X1, X2, Y1, Y2), die jeweils anderen beiden Teilsensoren (z.B. X3, X4, Y3, Y4) erfassen praktisch kein Signal. Das bedeutet, dass in Summe in diesem Ausführungsbeispiel ein Ausgangssignal mit vergleichsweise halber Intensität erzeugt wird.

Die Sensorelementanordnungen 104 und 106 erfassen folglich in diesem Ausführungsbeispiel im Vergleich zu einem Ausführungsbeispiel mit zwei Erregerleitungen das halbe Signal durch Erregung der Hälfte der Teilsensoren (z.B. X1, X2, Y1, Y2) mit vollem Magnetfeld. Die Sensorelementanordnung 102, die in diesem Ausführungsbeispiel das Magnetfeld in z-Richtung erfasst, erfasst im Vergleich zu einem Ausführungsbeispiel mit zwei Erregerleitungen das halbe Signal durch gleichmäßige Erregung aller Teilsensoren mit halbem Feld, da nur eine Spule verwendet wird.

Im Vergleich zu Ausführungsbeispielen mit zwei Erregerleitungen ergibt sich dann der halbe Signal-Hub, d.h. auch das halbe Signal-Rausch-Verhältnis. Zum Erreichen der gleichen Güte wie bei einer Erregung mit zwei Erregerleitungen kann deshalb eine Filterung der Messung bzw. eine längere Messung durchgeführt werden. Ferner werden bei den Sensorelementanordnungen 104 und 106 (z.B. X- und Y-Sensoren) nicht alle Teil-Sensoren (z.B. X1-X4, Y1-Y4) erregt. Beispielsweise werden in dem Ausführungsbeispiel gemäß der Fig. 3b mit nur einer Erregerleitung 108 die Einzelsensoren X3, X4, Y3 und Y4 nicht bzw. nur marginal magnetisch erregt. Damit erscheint ein magnetischer Test der Empfindlichkeit dieser Einzelsensoren zunächst nicht möglich, da diese aber baugleich zu den jeweils gegenüberliegenden Sensorelementen sind, kann von deren Erregung zurückgeschlossen bzw. zurückgerechnet werden. Ausgehend von einer symmetrischen Anordnung der Sensorelementanordnungen (z.B. 104, 106) kann dann zunächst auf je ein Sensorelement, z.B. 104b, eine Kalibrierfeldkomponente aufgeschaltet werden. Aufgrund der definierten Kalibrierfeldkomponente kann dann dieses Sensorelement kalibriert werden. Ferner kann aufgrund der gegebenen Symmetrie und der Verwendung gleicher Sensorelemente 104a und 104b, analog für die Sensorelemente 106a und 106b, kann dann auf die Kalibrierung des nicht unmittelbar mit der Kalibrierfeldkomponente erregte Sensorelement zurückgeschlossen werden.

Ausführungsbeispiele mit einer zweiten Erregerleitung 109 gemäß der Fig. 3b werden im Folgenden erläutert. Wie bereits oben erläutert kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

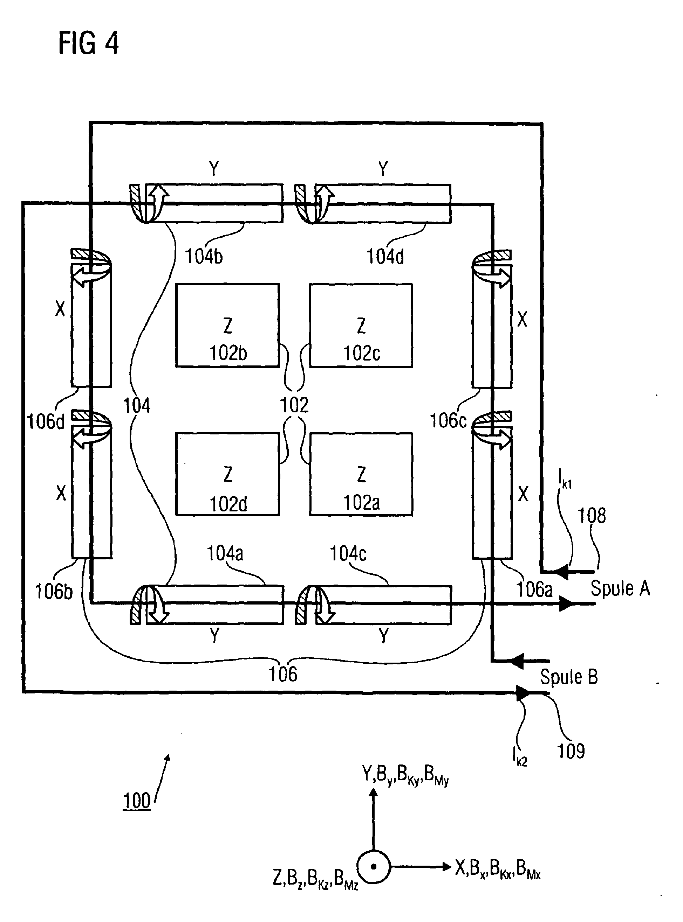

In der Fig. 4 ist ein weiteres Ausführungsbeispiel dargestellt. Die Fig. 4 zeigt eine erste Sensorelementanordnung 102, die beispielsweise durch vier horizontale Hall-Sensoren 102a, 102b, 102c und 102d realisiert sein kann. Ferner zeigt die Fig. 4 eine zweite Sensorelementanordnung 104, die durch vier vertikale Hall-Sensoren 104a, 104b, 104c und 104d realisiert sein kann. Weiterhin zeigt die Fig. 4 eine dritte Sensorelementanordnung 106, die durch vier vertikale Hall-Sensoren 106a, 106b, 106c und 106d realisiert sein kann. Zusätzlich sind in der Fig. 4 eine erste Erregerleitung 108 als Spule A und eine zweite Erregerleitung 109 als Spule B dargestellt. Dabei können beispielsweise Sensorelemente, 102a-d, 104a-d oder 106a-d gleicher Empfindlichkeit zum Einsatz kommen. Wie in der Fig. 4 dargestellt können in einem solchen Ausführungsbeispiel zwei Erregerleitungen 108 und 109 als zwei geometrisch zueinander verschobene Spulen realisiert werden.

Ausführungsbeispiele gemäß der Fig. 4 erlauben, zwei Magnetfelder der Spulen A und B zu überlagern und so ein resultierendes Erreger- oder Kalibrierungsfeld in einer Empfindlichkeitsrichtung zu erzeugen. Beispielsweise kann dabei eine Spule auf einer Seite der Anordnung direkt über den Sensorelementen angeordnet sein, wie z.B. Spule A bezüglich der Sensorelemente 104a, 104c, 106b und 106d, bzw. die Spule B bezüglich der Sensorelemente 104b, 104d, 106a und 106c in der Fig. 4. Ferner können dabei die Spulen an einer anderen Seite neben den Sensoren verlaufen, wie z.B. Spule B bezüglich der Sensorelemente 104a, 104c, 106b und 106d, bzw. die Spule A bezüglich der Sensorelemente 104b, 104d, 106a und 106c in der Fig. 4. In Ausführungsbeispielen können die Spulen also entgegengesetzt platziert bzw. angeordnet sein. Wie bereits oben erwähnt können auch hier vorzugsweise die Erregerleitungen (z.B. 108, 109) oder Spulen bezüglich der Sensorelemente paarweise symmetrisch angeordnet sein, dies braucht jedoch nicht notwendigerweise der Fall zu sein, sondern allgemein sind beliebige Geometrien denkbar, die es erlauben, definierte unterschiedliche Kalibrierfeldkomponenten innerhalb eine Sensorelementanordnung zu erzeugen.

Verläuft eine Spule direkt über vertikalen Sensorelementen, so ist ihr Einfluss auf diese deutlich größer als der Einfluss einer benachbarten oder seitlich versetzten Spule, dieser Einfluss kann in einem Ausführungsbeispiel auch vernachlässigbar sein. Demnach erregt die Spule A in der Fig. 4 hauptsächlich die vertikalen Sensorelemente 104a, 104c, 106b und 106d, bzw. die Spule B hauptsächlich die Sensorelemente 104b, 104d, 106a und 106c. Beide Spulen erregen die horizontalen Sensorelemente 102a-d in der Mitte der Anordnung. Die folgende Tabelle soll noch einmal für die beiden Spule getrennt wiedergeben, wie sich die Erregungsrichtung in Abhängigkeit der Richtung eines Erregerstromes verhält, aufgeschlüsselt nach den Sensorelementanordnungen 102, 104 und 106. Die Strompfeile in der Fig. 4 geben dabei die jeweils positive Stromrichtung an, d.h. ein positiver Strom $I_{k1}$ in der Spule A fließt zunächst an den Sensorelementen 106a, 106c, 104d und 104b seitlich vorbei und dann direkt oberhalb der Sensorelemente 106d, 106b, 104a und 104c, ein positiver Strom $I_{k2}$ in der Spule B fließt zunächst oberhalb der Sensorelemente 106a, 106c, 104d und 104b und dann seitlich vorbei and den Sensorelementen 106d, 106b, 104a und 104c.

|  | Erregerstrom | Erregung 106 | Erregung 104 | Erregung 102 |
|---|---|---|---|---|
| Spule A, $I_{k1}$ | + | + | + | + |
|  | - | - | - | - |
| Spule B, $I_{k2}$ | + | - | - | + |
|  | - | + | + | - |

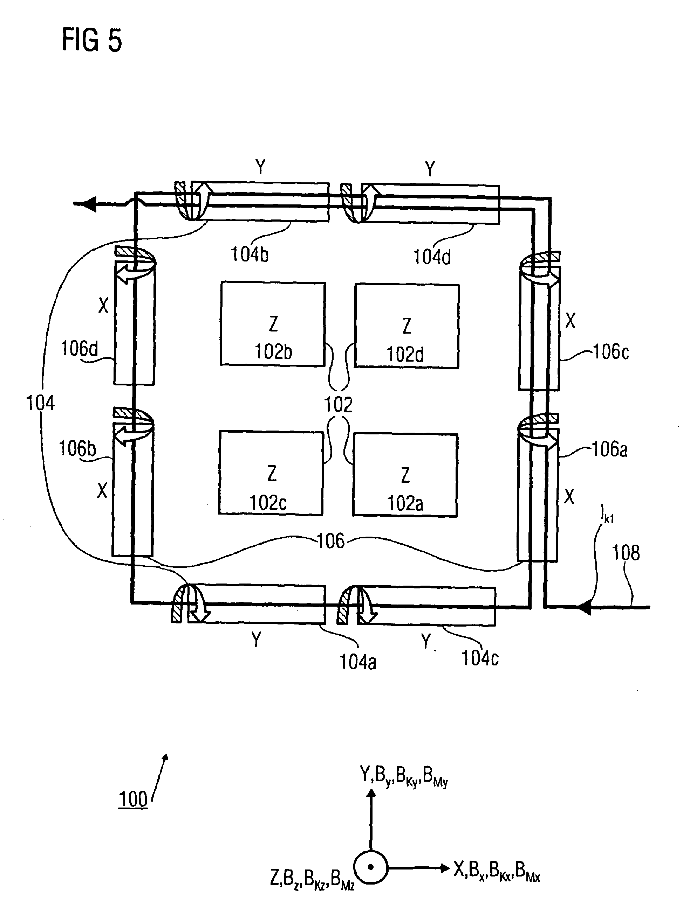

Die Fig. 5 zeigt ein weiteres Ausführungsbeispiel eines Magnetfeldsensors 100. Das Ausführungsbeispiel der Fig. 5 weist die gleichen Sensorelemente (z.B. 102a-d, 104a-d, 106a-d) und die gleiche Geometrie der Sensorelemente und Sensorelementanordnungen auf wie die Fig. 4, so dass auf eine wiederholte Beschreibung verzichtet wird. Der Magnetfeldsensor 100 der Fig. 5 weist nur eine Erregerleitung 108 auf, die als Spule mit 1,5 Windungen ausgeführt ist und direkt oberhalb der vertikalen Sensorelemente verläuft. Ein Strom $I_{k1}$ durch die Erregerleitung 108 in der Fig. 5 fließt demnach zweimal über die Sensorelemente 106a, 106c, 104b und 104d und nur einmal über die Sensorelemente 106d, 106b, 104a und 104c, wodurch die Unterschiedlichkeit bzw. die Asymmetrie der Kalibrierfeldkomponenten in den Paaren von Sensorelementen erreicht wird. In weiteren Ausführungsbeispielen kann der Magnetfeldsensor auch eine zweite Erregerleitung aufweisen die ebenfalls 1,5 Windungen aufweist und entsprechend obiger Beschreibung entgegengesetzt angeordnet sein kann. Generell sind Erregerleitungen mit verschiedenen Windungszahlen denkbar, die letztlich eine Teilwindung zum Erzeugen einer Asymmetrie der Kalibrierfeldkomponenten aufweisen.

In Ausführungsbeispielen ergeben sich verschiedene Messabläufe, die mit einer oder auch zwei Erregerleitungen 108, 109 realisierbar sind. Wird beispielsweise eine Spule bestromt, vgl. Figs. 1,2,3,5 sowie obige Tabelle, so können alle drei Sensoranordnungen 102, 104 und 106 erregt werden. Anhand der Ausführungsbeispiele in der Figs. 3b, 4 und der Tabelle ergibt sich bei einem positiven Strom $I_{k1}$ durch die Spule A eine positive Erregung aller Sensorelemente. Dabei werden alle horizontalen Sensorelemente 102a-d erregt, von den vertikalen Sensorelementen jedoch nur die Sensorelemente links (z.B. 106b, 106d) und unten (z.B. 104a, 104c). Die horizontalen Sensorelemente 102a-d werden mit dem vollen Magnetfeld der Spule A erregt, die vertikalen Sensorelemente (z.B. 104a, 104c, 106b, 106d) jedoch nur mit dem halben Magnetfeld, da nur jeweils zwei von vier Sensorelementen erregt werden.

Wird im Vergleich dazu nur die Spule B erregt, so erfahren die vertikalen Sensorelemente (z.B. 104a, 104b, 104d, 106a, 106c) eine negative Erregung und die horizontalen Sensorelemente (z.B. 102a-d) eine positive Erregung. Ähnlich wie oben werden alle horizontalen Sensorelemente (z.B. 102a-d) erregt und erfassen somit das volle Magnetfeld der Spule B. Von den vertikalen Sensorelementen werden analog (z.B. 104a-d, 106a-d) wieder nur die Hälfte erregt (z.B. 104a, 104b, 104d, 106a, 106c) und dadurch nur das halbe Magnetfeld der Spule B erfasst.

Durch Kombination der Ansteuerungen der Spulen A und B lassen sich in Ausführungsbeispielen die Magnetfeldsensoren überwachen und kalibrieren. Beispielsweise können auch beide Spulen in positiver Stromrichtung angesteuert werden. Dadurch werden die horizontalen Sensorelemente (z.B. 102a-d) mit dem doppelten Magnetfeld erregt und bei den vertikalen Sensorelementen (z.B. 104a-d, 106a-d) kann sich das Feld aufheben.

Werden beide Spulen in entgegengesetzter Richtung erregt, so können die vertikalen Sensorelemente (z.B. 104a-d, 106a-d) mit dem doppelten Feld angeregt werden, wobei sich das Feld bei den horizontalen Sensorelementen (z.B. 102a-d) aufhebt. In weiteren Ausführungsbeispielen können die Spulen auch mit unterschiedlich starken Strömen bestromt werden. Beispielsweise ergibt sich bei einer Bestromung in positiver Richtung beider Spulen, allerdings mit der doppelten Stromstärke in der ersten Spule A, für die horizontalen Sensorelemente (z.B. 102a-d) das dreifache Magnetfeld, für die vertikalen Sensorelemente (z.B. 106d, 106b, 104a, 104c) nur das einfache Magnetfeld. Ein solche Erregung kann in anderen Ausführungsbeispielen auch durch Spulen mit Teilwindungen, beispielsweise wie in der Fig. 5 gezeigt, erreicht werden. In der Fig. 5 würde dann die rechte Seite des Magnetfeldsensors 100 doppelt negativ erregt, während die linke Seite einfach positiv erregt werden würde, in Summe ergäbe sich also das dreifache Magnetfeld. Das Erregerverhältnis von 2:1 würde in einem solchen Ausführungsbeispiel nicht durch zwei Spulen, sondern durch eine Spule mit 1,5 Windungen realisiert. Generell sind in Ausführungsbeispielen Spulen mit beliebigen Windungszahlen denkbar die ein Erzeugen eines asymmetrischen Kalibrierfeldes erlauben, beispielsweise sind beliebige nicht-ganzzahlige Windungszahlen, die ein "unsymmetrisches" Erregerverhältnis erzeugen können, denkbar.

Wird in obigem Beispiel die erste Spule A mit dem doppelten Strom $I_{k1}$ und die zweite Spule B in entgegengesetzter Richtung bestromt, so sehen die horizontalen Sensorelemente (z.B. 102a-d) das einfache Magnetfeld, die vertikalen Sensoren (z.B. 104a-d, 106a-d) jedoch das Dreifache. Gemäß den betrachteten Beispielen lassen sich in weiteren Ausführungsbeispielen noch vielerlei anderen Kombinationen oder Ansteuerungen finden, um einzelne Magnetfeldkomponenten zu verstärken bzw. zu unterdrücken.

Jede diese Ansteuerungen hat Vorteile, je nachdem welche Komponente extrahiert oder unterdrückt werden soll. Sollen beispielsweise nur die vertikalen Sensorelemente (z.B. 104a-d, 106a-d) überwacht oder kalibriert werden, so könnte eine entgegengesetzte Bestromung der Spulen genutzt werden. Sollen beispielsweise nur die horizontalen Sensorelemente (z.B. 102a-d) erregt werden so könnten die Spulen in gleicher Richtung bestromt werden. Sind beide, sowohl die horizontalen (z.B. 102a-d) als auch die vertikalen Sensorelemente (z.B. 104a-d, 106a-d) von Interesse, so könnten die Spulen einzeln nacheinander oder mit unterschiedlichen Stromstärken gemäß obigen Beispielen bestromt werden.

Wie bereits oben erläutert kann bei den erläuterten Ausführungsbeispielen, jeweils eine Sensorelementanordnung 102, 104 oder 106 auch weggelassen werden. Die erläuterten Konzepte gelten dann uneingeschränkt auch für die verbleibenden beiden Sensorelementanordnungen zur Erfassung eines Magnetfeldes entlang zweier linear unabhängiger Raumrichtungen. Bzw. sind die Ausführungen bezüglich der Sensorelemente und deren Weiterbildungen jeweils gleichermaßen auch auf die Ausführungsbeispiele der Fign. 1a und 1b anwendbar.

Ein zusätzlicher Vorteil kann sich ergeben, wenn alle Sensorelemente (z.B. X1-X4, Y1-Y4) erregt werden. Dies lässt sich wie bereits oben erwähnt durch eine zweite Erregerleitung 109, vgl. Fig. 3b, erreichen, die dann beispielsweise zeitversetzt bestromt wird. Die folgende Tabelle fasst am Beispiel des in der Fig. 3b gezeigten Magnetfeldsensors, die Wirkungen der Bestromung der Erregerleitung 108 bzw. Spule A und der Erregerleitung 109 bzw. Spule B zusammen. Ein "+" bedeutet dabei Betromung bzw. magnetische Durchflutung in positiver Richtung, ein "-" in negativer Richtung und eine "0" bezeichnet kein Signal.

| Strom $I_{k1}$, SpuleA | Strom, $I_{k2}$ X1, SpuleB | Signal X2 | Signal Y1, Y2 | Signal X3, X4 | Signal Y3, Y4 | Signal X ges. | Signal Y ges. | Signal Z |
|---|---|---|---|---|---|---|---|---|
| + | 0 | + | + | 0 | 0 | + | + | + |
| - | 0 | - | - | 0 | 0 | - | - | - |
| 0 | + | 0 | 0 | - | - | - | - | + |
| 0 | - | 0 | 0 | + | + | + | + | - |
| + | + | + | + | - | - | 0 | 0 | ++ |
| + | - | + | + | + | + | ++ | ++ | 0 |
| - | + | - | - | - | - | -- | -- | 0 |
| - | - | - | - | + | + | 0 | 0 | -- |

Bei obiger Zusammenstellung wird ferner davon ausgegangen, dass der Strom durch beide Spulen gleich ist. Es könnten in anderen Ausführungsbeispielen, wie bereits in den vorhergehenden Abschnitten erwähnt, auch verschiedene Ströme bzw. Windungszahlen verwendet werden. Ein Vorteil ergibt sich in einem Ausführungsbeispiel beim abwechselnden Betrieb der Spulen. Es können dann Signalanteile in allen Sensorelementanordnungen 102, 104 und 106 erfasst werden, dies ist in obiger Tabelle in den drei rechten Spalten dargestellt.

Gemäß obigen Ausführungen können beim abwechselnden Betrieb nicht alle Sensorelemente einer Sensorelementanordnung gleichzeitig getestet werden. Beim gleichzeitigen Betrieb der Spulen ergibt sich dagegen ein Signal, das im Vergleich doppelt so hoch sein kann, wobei alle Sensorelemente einer Sensorelementanordnung gleichzeitig getestet werden können. Unterschiedliche Sensorelementanordnungen, z.B. 104/106 (z.B. X-, Y-Sensoren) und 102 (z.B. Z-Sensoren), können nur abwechselnd kalibriert oder getestet werden.

Zusammenfassend lässt sich bezüglich des erfindungsgemäßen Konzepts des im Messbetrieb kalibrierbaren magnetischen mehrdimensionalen Punktsensors feststellen, das Magnetsensoren gemäß den Ausführungsbeispielen der vorliegenden Erfindung also mit nur einem Erregerleiter auskommen, mit einer zweiten Erregerleitung aber zusätzliche Überwachungs- und Kalibrierungsmöglichkeiten bieten. Sie bieten den Vorteil, dass alle drei Feldkomponenten in sehr guter Näherung in einem Punkt gemessen werden können, wobei Offsets, die durch beispielsweise Bauteiltoleranzen, Verunreinigungen im Halbleitermaterial, Strukturinhomogenitäten im Halbleitermaterial usw. hervorgerufen werden, kompensiert werden können und die Messwerte damit Offset-arm zur Verfügung gestellt werden können. Durch die Verwendung der Erregerschleife, die auch beliebig viele Windungen bzw. Teilwindungen aufweisen kann, wird ein einfacher Wafer-Test, also ein Onchip-Test aller drei Sensoren ermöglicht. Weiterhin ist es durch das Kombinieren der Messsignale aus den einzelnen Erregungen möglich, im laufenden Messbetrieb einen Selbsttest zuzulassen, da sowohl Messsignalanteile, die auf die Messfeldkomponenten zurückgehen zum einen, als auch Messsignalanteile, die auf Kalibrierungsfeldkomponenten zurückgehen zum anderen erheblich reduzierbar sind. Es ist somit möglich, an einem solchen Magnetfeldsensor im laufenden Betrieb eine Empfindlichkeitskalibrierung durchzuführen. Die Erregerschleife selbst lässt sich ebenfalls testen, da ein Ausfall aller drei Sensoren mit getrennter Auswerteelektronik sehr unwahrscheinlich ist.

Insbesondere wird darauf hingewiesen, dass abhängig von den Gegebenheiten das erfindungsgemäße Schema auch in Software implementiert sein kann. Die Implementierung kann auf einem digitalen Speichermedium, insbesondere einer Diskette oder einer CD mit elektronisch auslesbaren Steuersignalen erfolgen, die so mit einem programmierbaren Computersystem und/oder Mikrocontroller zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner und/oder Mikrocontroller abläuft. In anderen Worten ausgedrückt kann die Erfindung somit als ein Computerprogramm mit einem Programmcode zur Durchführung des Verfahrens realisiert werden, wenn das Computerprogramm auf einem Computer und/oder Mikrocontroller abläuft.

Gemäß einem Ausführungsbeispiel ist bei einem Magnetfeldsensor 100 die Erregerleitung 108 derart angeordnet, dass die Spule mit der zumindest einen Windung, kürzeste Abstände zu den wenigstens zwei Sensorelementen 102a, 102b; 104a, 104b; 106a, 106b einer Sensorelementanordnung 102, 104, 106 aufweist, die unterschiedlich sind.

Gemäß einem Ausführungsbeispiel ist bei dem Magnetfeldsensor 100 die Erregerleitung 108 bezüglich des Referenzpunktes 101 symmetrisch angeordnet und überstreicht die Sensorelemente 102a, 102b; 104a, 104b; 106a, 106b einer Sensorelementanordnung 102; 104; 106 unterschiedlich oft.

Gemäß einem Ausführungsbeispiel ist bei dem Magnetfeldsensor 100 die Erregerleitung 108 derart angeordnet, dass sie eine Spule mit zumindest einer vollständigen Windung aufweist.

Gemäß einem Ausführungsbeispiel sind bei dem Magnetfeldsensor 100 die erste Erregerleitung 108 und die zweite Erregerleitung 109 derart angeordnet, dass das erste weitere Paar von unterschiedlichen asymmetrischen vorgegebenen Kalibrierungsfeldkomponenten in einer umgekehrten Relation zueinander steht als das erste Paar von Kalibrierungsfeldkomponenten, dass das zweite weitere Paar von unterschiedlichen asymmetrischen vorgegebenen Kalibrierungsfeldkomponenten in einer umgekehrten Relation zueinander steht als das zweite Paar von Kalibrierungsfeldkomponenten, und dass das dritte weitere Paar von unterschiedlichen asymmetrischen vorgegebenen Kalibrierungsfeldkomponenten in einer umgekehrten Relation zueinander steht als das dritte Paar von Kalibrierungsfeldkomponenten.

Gemäß einem Ausführungsbeispiel weist bei dem Magnetfeldsensor 100 die zweite oder dritte Sensorelementanordnung 102 ein bezüglich einer Hauptoberfläche des Magnetfeldsensors horizontales Hall-Sensorelement auf.

Gemäß einem Ausführungsbeispiel weist bei dem Magnetfeldsensor 100 die zweite oder dritte Sensorelementanordnung 102 eine Mehrzahl von bezüglich einer Hauptoberfläche des Magnetfeldsensors horizontalen Hall-Sensorelementen auf, wobei die geometrische Anordnung der Mehrzahl von horizontalen Hall-Sensorelementen bezüglich des Referenzpunktes 101 paarweise symmetrisch ist und die Hall-Sensorelemente derart miteinander gekoppelt sind, dass die Magnetfeldkomponente Offset-kompensiert erfassbar ist.

Gemäß einem Ausführungsbeispiel sind bei dem Magnetfeldsensor die erste 102, zweite 104 oder dritte Sensorelementanordnung 106 im Spinning-Current-Modus betreibbar.

Gemäß einem Ausführungsbeispiel umfasst ein Verfahren ferner einen Schritt des Erzeugens der ersten, zweiten und dritten weiteren Kalibrierungsfeldkomponente $B_{Kz2}$, $B_{Ky2}$, $B_{Kx2}$ bezüglich der ersten, zweiten und dritten Raumachse z, y, x, und einen Schritt des Erfassens der ersten, zweiten und dritten weiteren Magnetfeldkomponente $B_{z2}$, $B_{y2}$, $B_{x2}$, die erste, zweite und dritte weitere Messfeldkomponenten $B_{Mz2}$, $B_{My2}$, $B_{Mx2}$ und/oder erste, zweite und dritte Kalibrierungsfeldkomponenten $B_{Kz2}$, $B_{Ky2}$, $B_{Kx2}$ aufweist.

Gemäß einem Ausführungsbeispiel erfolgt bei dem Verfahren der Schritt des ersten linearen Kombinierens der den Magnetfeldkomponenten oder den weiteren Magnetfeldkomponenten zugeordneten Messsignale einer Magnetfeldkomponente zu einem ersten Gesamtmesswert derart, dass ein Anteil der Messfeldkomponente in dem ersten Gesamtmesswert auf weniger als 10%, 1% oder 0,1% des ersten Gesamtmesswertes reduziert wird.

Gemäß einem Ausführungsbeispiel erfolgt bei dem Verfahren der Schritt des zweiten Kombinierens der den Magnetfeldkomponenten oder den weiteren Magnetfeldkomponenten zugeordneten Messsignale einer Magnetfeldkomponente zu einem zweiten Gesamtmesswert derart, dass der Anteil der Kalibrierungsfeldkomponente in dem zweiten Gesamtmesswert auf weniger als 10%, 1% oder 0,1% des zweiten Gesamtmesswertes reduziert wird.

Gemäß einem Ausführungsbeispiel umfasst das Verfahren ferner einen Schritt des Kombinierens der den Magnetfeldkomponenten oder den weiteren Magnetfeldkomponenten zugeordneten Messsignale einer Magnetfeldkomponente, so dass die Magnetfeldkomponente Offset-kompensiert erfassbar wird.

Gemäß einem Ausführungsbeispiel werden bei dem Verfahren Betriebsphasen gemäß einem Spinning-Current-Verfahren durchgeführt.

## Patentansprüche

1. Kalibrierbarer Magnetfeldsensor (100) zur Erfassung einer ersten und einer zweiten räumlichen Komponente ($B_y$, $B_z$; $B_x$, $B_y$) eines Magnetfeldes in einem Referenzpunkt (101), wobei das Magnetfeld eine erste und eine zweite Messfeldkomponente ($B_{My}$, $B_{Mz}$; $B_{Mx}$, $B_{My}$) und/oder eine erste und zweite Kalibrierungsfeldkomponente ($B_{Ky}$, $B_{Kz}$; $B_{Kx}$, $B_{Ky}$) aufweist, mit folgenden Merkmalen:

   einer ersten Sensorelementanordnung (104; 106), die wenigstens ein erstes und ein zweites Sensorelement (104a, 104b; 106a, 106b) aufweist, zur Erfassung der ersten Magnetfeldkomponente ($B_y$; $B_x$), die eine erste Messfeldkomponente ($B_{My}$; $B_{Mx}$) und/oder eine erste Kalibrierungsfeldkomponente ($B_{Ky}$; $B_{Kx}$) aufweist, bezüglich einer ersten Raumachse (y; x) im Referenzpunkt (101) ;
   einer zweiten Sensorelementanordnung (102; 104) zur Erfassung der zweiten Magnetfeldkomponente ($B_z$; $B_y$), die eine zweite Messfeldkomponente ($B_{Mz}$; $B_{My}$) und/oder eine zweite Kalibrierungsfeldkomponente ($B_{Kz}$; $B_{Ky}$) aufweist, bezüglich einer zweiten Raumachse (z; y) im Referenzpunkt (101), wobei die zwei Raumachsen (y, z; x, z; x, y) entlang linear unabhängiger Ortsvektoren verlaufen;
   einer Erregerleitung (108), die so bezüglich der ersten Sensorelementanordnung (104; 106) angeordnet ist, dass bei einer Einprägung eines vorgegebenen Stroms ($I_{k1}$) in die Erregerleitung (108) ein Paar von unterschiedlichen asymmetrischen vorgegebenen Kalibrierungsfeldkomponenten ($B_{Kya}$; $B_{Kxa}$) in dem ersten Sensorelement (104a; 106a) und ($B_{Kyb}$; $B_{Kxb}$) in dem zweiten Sensorelement (104b; 106b) bezüglich der ersten Raumachse (y; x) erzeugt wird.

2. Kalibrierbarer Magnetfeldsensor (100) gemäß Anspruch 1, bei dem die zweite Sensorelementanordnung (102; 104) wenigstens ein erstes und ein zweites Sensorelement (102a, 102b; 104a, 104b) aufweist und die Erregerleitung (108) ferner so bezüglich der zweiten Sensorelementanordnung (102; 104) angeordnet ist, dass ein zweites Paar von unterschiedlichen asymmetrischen vorgegebenen Kalibrierungsfeldkomponenten ($B_{Kza}$; $B_{Kya}$) in dem ersten Sensorelement (102a; 104a) und ($B_{Kzb}$; $B_{Kyb}$) in dem zweiten Sensorelement (102b; 104b) bezüglich der zweiten Raumachse (z; y) in der zweiten Sensorelementanordnung (102; 104) erzeugt wird.

3. Kalibrierbarer Magnetfeldsensor (100) gemäß einem der Ansprüche 1 oder 2, der ferner ausgebildet ist, um eine dritte räumliche Komponente ($B_x$; $B_z$) des Magnetfeldes in dem Referenzpunkt (101) zu erfassen, wobei das Magnetfeld ferner eine dritte Messfeldkomponente ($B_{Mx}$; $B_{Mz}$) und/oder eine dritte Kalibrierungsfeldkomponente ($B_{Kx}$; $B_{Kz}$) aufweist und der Magnetfeldsensor (100) ferner eine dritte Sensorelementanordnung (106; 102) aufweist, zur Erfassung der dritten Magnetfeldkomponente ($B_x$; $B_z$), die die dritte Messfeldkomponente ($B_{Mx}$; $B_{Mz}$) und/oder die dritte Kalibrierungsfeldkomponente ($B_{Kx}$; $B_{Kz}$) aufweist, bezüglich einer dritten Raumachse (x; z) im Referenzpunkt (101), wobei die drei Raumachsen (z, y, x) entlang linear unabhängiger Ortsvektoren verlaufen.

4. Kalibrierbarer Magnetfeldsensor (100) gemäß Anspruch 3, wobei die dritte Sensorelementanordnung (106; 102) wenigstens ein erstes und ein zweites Sensorelement (106a, 106b; 102a, 102b) aufweist und wobei die Erregerleitung (108) so bezüglich der dritten Sensorelementanordnung (106; 102) angeordnet ist, dass bei einer Einprägung eines vorgegebenen Stroms ($I_{k1}$) in die Erregerleitung (108) ein Paar von unterschiedlichen asymmetrischen vorgegebenen Kalibrierungsfeldkomponenten ($B_{Kxa}$, $B_{Kxb}$; $B_{Kza}$, $B_{Kzb}$) in dem ersten Sensorelement (106a; 102a) und in dem zweiten Sensorelement (106b; 102b) bezüglich der dritten Raumachse (x; z) in der dritten Sensorelementanordnung (106; 102) erzeugt wird.

5. Magnetfeldsensor (100) gemäß einem der Ansprüche 1 bis 4, bei dem die Erregerleitung (108) derart ausgebildet ist, dass sie eine Teilwindung aufweist.

6. Magnetfeldsensor (100) gemäß einem der Ansprüche 1 bis 5, der ferner eine zweite Erregerleitung (109) aufweist.

7. Magnetfeldsensor (100) gemäß Anspruch 6, bei dem die zweite Erregerleitung (109) so bezüglich der ersten (102), zweiten (104) oder dritten Sensorelementanordnung (106) angeordnet ist, um bei einer Einprägung eines weiteren vorgegebenen Stroms ($I_{k2}$) in die zweite Erregerleitung (109) ein erstes weiteres Paar von unterschiedlichen asymmetrischen vorgegebenen Kalibrierungsfeldkomponenten ($B_{Kza2}$, $B_{Kzb2}$) in dem ersten Sensorelement (102a) und in dem zweiten Sensorelement (102b) bezüglich der ersten Raumachse (z) in der ersten Sensorelementanordnung (102) zu erzeugen, ein zweites weiteres Paar von unterschiedlichen asymmetrischen vorgegebenen Kalibrierungsfeldkomponenten ($B_{Kya2}$, $B_{Kyb2}$) in dem ersten Sensorelement (104a) und in dem zweiten Sensorelement (104b) bezüglich der zweiten Raumachse (y) in der zweiten Sensorelementanordnung (104) zu erzeugen oder ein drittes weiteres Paar von unterschiedlichen asymmetrischen vorgegebenen Kalibrierungsfeldkomponenten ($B_{Kxa2}$, $B_{Kxb2}$) in dem ersten Sensorelement (106a) und in dem zweiten Sensorelement (106b) bezüglich der dritten Raumachse (x) in der dritten Sensorelementanordnung (106) zu erzeugen.

8. Magnetfeldsensor (100) gemäß einem der Ansprüche 1 bis 7, wobei die erste, zweite oder dritte Sensorelementanordnung (104; 106) zumindest zwei bezüglich einer Hauptoberfläche des Magnetfeldsensors vertikale Hall-Sensorelemente aufweist, wobei die geometrische Anordnung der mindestens zwei vertikalen Hall-Sensorelemente bezüglich des Referenzpunktes (101) paarweise symmetrisch ist, und die derart miteinander gekoppelt sind, dass die Magnetfeldkomponente Offset-kompensiert erfassbar ist.

9. Verfahren zur Erfassung einer ersten und einer zweiten räumlichen Komponente ($B_y$, $B_z$; $B_x$, $B_y$) eines Magnetfeldes in einem Referenzpunkt (101), wobei das Magnetfeld eine erste und eine zweite Messfeldkomponente ($B_{My}$, $B_{Mz}$; $B_{Mx}$, $B_{My}$) und/oder eine erste und zweite Kalibrierungsfeldkomponente ($B_{Ky}$, $B_{Kz}$; $B_{Kx}$, $B_{Ky}$) aufweist, mit folgenden Schritten:

Erfassen, in einem ersten und einem zweitem Sensorelement (104a, 104b; 106a, 106b) einer ersten Sensorelementanordnung (104; 106), eines ersten Paares von Magnetfeldkomponenten ($B_{ya}$, $B_{yb}$; $B_{xa}$, $B_{xb}$), die erste Messfeldkomponenten ($B_{Mya}$, $B_{Myb}$; $B_{Mxa}$, $B_{Mxb}$) und/oder erste Kalibrierungsfeldkomponenten ($B_{Kya}$, $B_{Kyb}$; $B_{Kxa}$, $B_{Kxb}$) aufweisen, bezüglich einer ersten Raumachse (y; x) im Referenzpunkt (101);
Erfassen, in einer zweiten Sensorelementanordnung (102; 104), zweiter Magnetfeldkomponenten ($B_z$; $B_y$), die zweite Messfeldkomponenten ($B_{Mz}$; $B_{My}$) und/oder zweite Kalibrierungsfeldkomponenten ($B_{Kz}$; $B_{Ky}$) aufweisen, bezüglich einer zweiten Raumachse (z; y) im Referenzpunkt (101), wobei die zwei Raumachsen (y, z; x, y) entlang linear unabhängiger Ortsvektoren verlaufen; und
Erzeugen eines ersten Paares von unterschiedlichen asymmetrischen Kalibrierungsfeldkomponenten ($B_{Kya}$, $B_{Kyb}$; $B_{Kxa}$, $B_{Kxb}$) bezüglich der ersten Raumachse (x; y) in dem ersten und dem zweitem Sensorelement (104a, 104b; 106a, 106b) der ersten Sensorelementanordnung (104; 106).

10. Verfahren gemäß Anspruch 9, mit ferner Folgenden Schritten:

Erfassen eines zweiten Paares von Magnetfeldkomponenten ($B_{za}$, $B_{zb}$; $B_{ya}$, $B_{yb}$), die zweite Messfeldkomponenten ($B_{Mza}$, $B_{Mzb}$; $B_{Mya}$, $B_{Myb}$) und/oder zweite Kalibrierungsfeldkomponenten ($B_{Kza}$, $B_{Kzb}$; $B_{Kya}$, $B_{Kyb}$) aufweisen, bezüglich der zweiten Raumachse (z; y) im Referenzpunkt (101); und
Erzeugen des zweiten Paares von unterschiedlichen asymmetrischen Kalibrierungsfeldkomponenten ($B_{Kza}$, $B_{Kzb}$; $B_{Kya}$, $B_{Kyb}$) bezüglich der zweiten Raumachse (z; y).

11. Verfahren gemäß einem der Ansprüche 9 oder 10, ferner mit folgenden Schritten:

Erfassen einer dritten räumlichen Komponente ($B_x$; $B_z$) des Magnetfeldes in dem Referenzpunkt (101), wobei das Magnetfeld ferner eine dritte Messfeldkomponente ($B_{Mx}$; $B_{Mz}$) und/oder ferner eine dritte Kalibrierungsfeldkomponente ($B_{Kx}$; $B_{Kz}$) aufweist; und
Erzeugen dritter Kalibrierungsfeldkomponenten ($B_{Kx}$; $B_{Kz}$) bezüglich einer dritten Raumachse (x; z), wobei die drei Raumachsen (z, y, x) entlang linear unabhängiger Ortsvektoren verlaufen.

**12.** Verfahren gemäß Anspruch 11, ferner mit folgenden Schritten:

Erfassen eines dritten Paares von Magnetfeldkomponenten ($B_{xa}$, $B_{xb}$; $B_{za}$, $B_{zb}$), die dritte Messfeldkomponenten ($B_{Mxa}$, $B_{Mxb}$; $B_{Mza}$, $B_{Mzb}$) und/oder dritte Kalibrierungsfeldkomponenten ($B_{Kxa}$, $B_{Kxb}$; $B_{Kza}$, $B_{Kzb}$) aufweisen, bezüglich der dritten Raumachse (x; z) im Referenzpunkt (101); und
Erzeugen des dritten Paares von unterschiedlichen $\alpha$symmetrischen Kalibrierungsfeldkomponenten ($B_{Kxa}$, $B_{Kxb}$; $B_{Kza}$, $B_{Kzb}$) bezüglich der dritten Raumachse (x; z).

**13.** Verfahren gemäß den Ansprüchen 9 bis 12, ferner mit folgenden Schritten:

Erstes lineares Kombinieren der den Magnetfeldkomponenten zugeordneten Messsignale einer Magnetfeldkomponente zu einem ersten Gesamtmesswert, um den Einfluss der Messfeldkomponente in dem ersten Gesamtmesswert zu reduzieren; oder
Zweites lineares Kombinieren der den weiteren Magnetfeldkomponenten zugeordneten Messsignale einer Magnetfeldkomponente zu einem zweiten Gesamtmesswert, um den Einfluss der Kalibrierungsfeldkomponente in dem zweiten gesamten Messwert zu reduzieren.

**14.** Verfahren gemäß einem der Ansprüche 9 bis 13, ferner mit folgenden Schritten:

Speichern von Erregerstromstärken, Messfeldkomponenten oder Kalibrierungsfeldkomponenten zur Kalibrierung;
Zuordnen der Erregerstromstärken zu Kalibrierungsfeldkomponenten oder Magnetfeldstärken; und
Bereitstellen von Wertepaaren vom Messfeldkomponenten und Magnetfeldstärken.

**15.** Computerprogramm mit einem Programmcode zur Durchführung aller Schritte eines der Verfahren der Ansprüche 9 bis 14, wenn der Programmcode auf einem Computer abläuft.

**Claims**

**1.** Calibratable magnetic field sensor (100) for sensing a first and a second spatial component ($B_y$, $B_z$; $B_x$, $B_y$) of a magnetic field in a reference point (101), wherein the magnetic field comprises a first and a second measurement field component ($B_{My}$, $B_{Mz}$; $B_{Mx}$, $B_{My}$) and/or a first and a second calibration field component ($B_{Ky}$, $B_{Kz}$; $B_{Kx}$, $B_{Ky}$), comprising:

a first sensor element arrangement (104; 106) comprising at least a first and a second sensor element (104a, 104b; 106a, 106b) for sensing the first magnetic field component ($B_y$; $B_x$), which comprises a first measurement field component ($B_{My}$; $B_{Mx}$) and/or a first calibration field component ($B_{Ky}$; $B_{Kx}$), with respect to a first spatial axis (y; x) in the reference point (101);
a second sensor element arrangement (102; 104) for sensing the second magnetic field component ($B_z$; $B_y$), which comprises a second measurement field component ($B_{Mz}$; $B_{My}$) and/or a second calibration field component ($B_{Kz}$; $B_{Ky}$), with respect to a second spatial axis (z; y) in the reference point (101), wherein the two spatial axes (y, z; x, z; x, y) pass along linearly independent position vectors;
an excitation line (108) arranged with respect to the first sensor element arrangement (104; 106) so that, when impressing a default current ($I_{k1}$) into the excitation line (108), a pair of different asymmetrical default calibration field components ($B_{Kya}$; $B_{Kxa}$) in the first sensor element (104a; 106a) and ($B_{Kyb}$; $B_{Kxb}$) in the second sensor element (104b; 106b) is generated with respect to the first spatial axis (y; x).

**2.** Calibratable magnetic field sensor (100) according to claim 1, wherein the second sensor element arrangement (102; 104) comprises at least a first and a second sensor element (102a, 102b; 104a, 104b), and the excitation line (108) further is arranged with respect to the second sensor element arrangement (102; 104) so that a second pair of different asymmetrical default calibration field components ($B_{Kza}$; $B_{Kya}$) in the first sensor element (102a; 104a) and ($B_{Kzb}$; $B_{Kyb}$) in the second sensor element (102b; 104b) is generated with respect to the second spatial axis (z; y) in the second sensor element arrangement (102; 104).

3. Calibratable magnetic field sensor (100) according to one of claims 1 or 2, further formed to sense a third spatial component ($B_x$; $B_z$) of the magnetic field in the reference point (101), wherein the magnetic field further comprises a third measurement field component ($B_{Mx}$; $B_{Mz}$) and/or a third calibration field component ($B_{Kx}$; $B_{Kz}$), and the magnetic field sensor (100) further comprises a third sensor element arrangement (106; 102) for sensing the third magnetic field component ($B_x$; $B_z$), which comprises the third measurement field component ($B_{Mx}$; $B_{Mz}$) and/or the third calibration field component ($B_{Kx}$; $B_{Kz}$), with respect to a third spatial axis (x; z) in the reference point (101), wherein the three spatial axes (z, y, x) pass along linearly independent position vectors.

4. Calibratable magnetic field sensor (100) according to claim 3, wherein the third sensor element arrangement (106; 102) comprises at least a first and a second sensor element (106a, 106b; 102a, 102b), and wherein the excitation line (108) is arranged with respect to the third sensor element arrangement (106; 102) so that, when impressing a default current ($I_{k1}$) into the excitation line (108), a pair of different asymmetrical default calibration field components ($B_{Kxa}$, $B_{Kxb}$; $B_{Kza}$, $B_{Kzb}$) in the first sensor element (106a; 102a) and in the second sensor element (106b; 102b) is generated with respect to the third spatial axis (x; z) in the third sensor element arrangement (106; 102).

5. Magnetic field sensor (100) according to one of claims 1 to 4, wherein the excitation line (108) is formed such that it comprises a partial winding.

6. Magnetic field sensor (100) according to one of claims 1 to 5, further comprising a second excitation line (109).

7. Magnetic field sensor (100) according to claim 6, wherein the second excitation line (109) is arranged with respect to the first (102), second (104) or third sensor element arrangement (106) so as to generate a first further pair of different asymmetrical default calibration field components ($B_{Kza2}$, $B_{Kzb2}$) in the first sensor element (102a) and in the second sensor element (102b) with respect to the first spatial axis (z) in the first sensor element arrangement (102) when impressing a further default current ($I_{k2}$) into the second excitation line (109), to generate a second further pair of different asymmetrical default calibration field components ($B_{Kya2}$, $B_{Kyb2}$) in the first sensor element (104a) and in the second sensor element (104b) with respect to the second spatial axis (y) in the second sensor element arrangement (104), or to generate a third further pair of different asymmetrical default calibration field components ($B_{Ksa2}$, $B_{Kxb2}$) in the first sensor element (106a) and in the second sensor element (106b) with respect to the third spatial axis (x) in the third sensor element arrangement (106).

8. Magnetic field sensor (100) according to one of claims 1 to 7, wherein the first, second or third sensor element arrangement (104; 106) comprises at least two hall sensor elements vertical with respect to a main surface of the magnetic field sensor, wherein the geometrical arrangement of the at least two vertical hall sensor elements with respect to the reference point (101) is symmetrical in pairs, and the same are coupled to each other such that the magnetic field component can be sensed in an offset-compensated manner.

9. Method for sensing a first and a second spatial component ($B_y$, $B_z$; $B_x$, $B_y$) of a magnetic field in a reference point (101), wherein the magnetic field comprises a first and a second measurement field component ($B_{My}$, $B_{Mz}$; $B_{Mx}$, $B_{My}$) and/or a first and a second calibration field component ($B_{Ky}$, $B_{Kz}$; $B_{Kx}$, $B_{Ky}$), comprising:

sensing, in a first and a second sensor element (104a, 104b; 106a, 106b) of a first sensor element arrangement (104; 106), a first pair of magnetic field components ($B_{ya}$, $B_{yb}$; $B_{xa}$, $B_{xb}$), which comprise first measurement field components ($B_{Mya}$, $B_{Myb}$; $B_{Mxa}$, $B_{Mxb}$) and/or first calibration field components ($B_{Kya}$, $B_{Kyb}$; $B_{Kxa}$, $B_{Kxb}$), with respect to a first spatial axis (y; x) in the reference point (101);
sensing, in a second sensor element arrangement (102; 104), second magnetic field components ($B_z$; $B_y$), which comprise second measurement field components ($B_{Mz}$; $B_{My}$) and/or second calibration field components ($B_{Kz}$; $B_{Ky}$), with respect to a second spatial axis (z; y) in the reference point (101), wherein the two spatial axes (y, z; x, y) pass along linearly independent position vectors; and
generating a first pair of different asymmetrical calibration field components ($B_{Kya}$, $B_{Kyb}$; $B_{Kxa}$, $B_{Kxb}$) with respect to the first spatial axis (y; x) in the first and the second sensor element (104a, 104b; 106a, 106b) of the first sensor element arrangement (104; 106).

10. Method according to claim 9, further comprising:

sensing a second pair of magnetic field components ($B_{za}$, $B_{zb}$; $B_{ya}$, $B_{yb}$), which comprise second measurement field components ($B_{Mza}$, $B_{Mzb}$; $B_{Mya}$, $B_{Myb}$) and/or second calibration field components ($B_{Kza}$, $B_{Kzb}$; $B_{Kya}$, $B_{Kyb}$), with respect to the second spatial axis (z; y) in the reference point (101); and

generating the second pair of different asymmetrical calibration field components ($B_{Kza}$, $B_{Kzb}$; $B_{Kya}$, $B_{Kyb}$) with respect to the second spatial axis (z; y).

11. Method according to one of claims 9 or 10, further comprising:

sensing a third spatial component ($B_x$; $B_z$) of the magnetic field in the reference point (101), wherein the magnetic field further comprises a third measurement field component ($B_{Mx}$; $B_{Mz}$) and/or a third calibration field component ($B_{Kx}$; $B_{Kz}$); and
generating third calibration field components ($B_{Kx}$; $B_{Kz}$) with respect to the third spatial axis (x; z), wherein the three spatial axes (z, y, x) pass along linearly independent position vectors.

12. Method according to claim 11, further comprising:

sensing a third pair of magnetic field components ($B_{xa}$, $B_{xb}$; $B_{za}$, $B_{zb}$), which comprise third measurement field components ($B_{Mxa}$, $B_{Mxb}$; $B_{Mza}$, $B_{Mzb}$) and/or third calibration field components ($B_{Kxa}$, $B_{Kxb}$; $B_{Kza}$, $B_{Kzb}$), with respect to the third spatial axis (x; z) in the reference point (101); and
generating the third pair of different asymmetrical calibration field components ($B_{Kxa}$, $B_{Kxb}$; $B_{Kza}$, $B_{Kzb}$) with respect to the third spatial axis (x; z).

13. Method according to one of claims 9 to 12, further comprising:

first linearly combining the measurement signals of a magnetic field component, which are associated with the magnetic field components, to a first total measurement value, in order to reduce the influence of the measurement field component in the first total measurement value; or
second linearly combining the measurement signals of a magnetic field component, which are associated with the further magnetic field components, to a second total measurement value, in order to reduce the influence of the calibration field component in the second total measurement value.

14. Method according to one of claims 9 to 13, further comprising:

storing excitation current strengths, measurement field components or calibration field components for calibration;
associating the excitation current strengths with calibration field components or magnetic field strengths; and
providing value pairs of measurement field components and magnetic field strengths.

15. Computer program with a program code for performing all of the steps of one of the methods of claims 9 to 14, when the program code is executed on a computer.

**Revendications**

1. Capteur de champ magnétique étalonnable (100) destiné à capter une première et une deuxième composante spatiale ($B_y$, $B_z$; $B_x$, $B_y$) d'un champ magnétique à un point de référence (101), le champ magnétique présentant une première et une deuxième composante de champ de mesure ($B_{My}$, $B_{Mz}$; $B_{Mx}$, $B_{My}$) et/ou une première et une deuxième composante de champ d'étalonnage ($B_{Ky}$, $B_{Kz}$; $B_{Kx}$, $B_{Ky}$), aux caractéristiques suivantes:

un premier aménagement d'éléments capteurs (104; 106) présentant au moins un premier et un deuxième élément capteur (104a, 104b; 106a, 106b), destiné à capter la première composante de champ magnétique ($B_y$; $B_x$) présentant une première composante de champ mesure ($B_{My}$; $B_{Mx}$) et/ou une première composante de champ d'étalonnage ($B_{Ky}$; $B_{Kx}$), par rapport à un premier axe spatial (y; x) au point de référence (101);
un deuxième aménagement d'éléments capteurs (102; 104) destiné à capter la deuxième composante de champ magnétique ($B_z$; $B_y$) présentant une deuxième composante de champ mesure ($B_{Mz}$; $B_{My}$) et/ou une deuxième composante de champ d'étalonnage ($B_{Kz}$; $B_{Ky}$), par rapport à un deuxième axe spatial (z; y) au point de référence (101), les deux axes spatiaux (y, z; x, z; x, y) s'étendant le long de vecteurs de lieu indépendants;
une ligne d'excitation (108) qui est disposée par rapport au premier aménagement d'éléments capteurs (104; 106) de sorte qu'il soit généré, lors d'une application d'un courant prédéterminé ($I_{k1}$) dans la ligne d'excitation (108), une paire de composantes de champ d'étalonnage prédéterminées asymétriques différentes ($B_{Kya}$; $B_{Kxa}$) dans le premier élément capteur (104a; 106a) et ($B_{Kyb}$; $B_{Kxb}$) dans le deuxième élément capteur (104b; 106b) par rapport au premier axe spatial (y; x).

**2.** Capteur de champ magnétique étalonnable (100) selon la revendication 1, dans lequel le deuxième aménagement d'éléments capteurs (102; 104) présente au moins un premier et un deuxième élément capteur (102a, 102b; 104a, 104b) et la ligne d'excitation (108) est par ailleurs disposée par rapport au deuxième aménagement d'éléments capteurs (102; 104) de sorte qu'il soit généré une deuxième paire de composantes de champ d'étalonnage prédéterminées asymétriques différentes ($B_{Kza}$; $B_{Kya}$) dans le premier élément capteur (102a; 104a) et ($B_{Kzb}$; $B_{Kyb}$) dans le deuxième élément capteur (102b; 104b) par rapport au deuxième axe spatial (z; y) dans le deuxième aménagement d'éléments capteurs (102; 104).

**3.** Capteur de champ magnétique étalonnable (100) selon l'une des revendications 1 ou 2, qui est par ailleurs réalisé pour capter une troisième composante spatiale ($B_x$; $B_z$) du champ magnétique au point de référence (101), le champ magnétique présentant par ailleurs une troisième composante de champ mesure ($B_{Mx}$; $B_{Mz}$) et/ou une troisième composante de champ d'étalonnage ($B_{Kx}$; $B_{Kz}$) et le capteur de champ magnétique (100) présentant par ailleurs un troisième aménagement d'éléments capteurs (106; 102) destiné à capter la troisième composante de champ magnétique ($B_x$; $B_z$) présentant la troisième composante de champ mesure ($B_{Mx}$; $B_{Mz}$) et/ou la troisième composante de champ d'étalonnage ($B_{Kx}$; $B_{Kz}$), par rapport à un troisième axe spatial (x; z) au point de référence (101), les trois axes spatiaux (z, y, x) s'étendant le long de vecteurs de lieu linéairement indépendants.

**4.** Capteur de champ magnétique étalonnable (100) selon la revendication 3, dans lequel le troisième aménagement d'éléments capteurs (106; 102) présente au moins un premier et un deuxième élément capteur (106a, 106b; 102a, 102b) et la ligne d'excitation (108) étant disposée par rapport au troisième aménagement d'éléments capteurs (106; 102) de sorte qu'il soit généré, lors de l'application d'un courant prédéterminé ($I_{k1}$) dans la ligne d'excitation (108), une paire de composantes de champ d'étalonnage prédéterminées asymétriques différentes ($B_{Kxa}$, $B_{Kxb}$; $B_{Kza}$, $B_{Kzb}$) dans le premier élément capteur (106a; 102a) et dans le deuxième élément capteur (106b; 102b) par rapport au troisième axe spatial (x; z) dans le troisième aménagement d'éléments capteurs (106; 102).

**5.** Capteur de champ magnétique (100) selon l'une des revendications 1 à 4, dans lequel la ligne d'excitation (108) est réalisée de sorte qu'elle présente un enroulement partiel.

**6.** Capteur de champ magnétique (100) selon l'une des revendications 1 à 5, qui présente par ailleurs une deuxième ligne d'excitation (109).

**7.** Capteur de champ magnétique (100) selon la revendication 6, dans lequel la deuxième ligne d'excitation (109) est disposée par rapport au premier (102), au deuxième (104) ou au troisième aménagement d'éléments capteurs (106) de manière à générer, lors de l'application d'un autre courant prédéterminé ($I_{k2}$) dans la deuxième ligne d'excitation (109), une première autre paire de composantes de champ d'étalonnage prédéterminées asymétriques différentes ($B_{Kza2}$, $B_{Kzb2}$) dans le premier élément capteur (102a) et dans le deuxième élément capteur (102b) par rapport au premier axe spatial (z) dans le premier aménagement d'éléments capteurs (102), une deuxième autre paire de composantes de champ d'étalonnage prédéterminées asymétriques différentes ($B_{Kya2}$, $B_{Kyb2}$) dans le premier élément capteur (104a) et dans le deuxième élément capteur (104b) par rapport au deuxième axe spatial (y) dans le deuxième aménagement d'éléments capteurs (104) ou à générer une troisième autre paire de composantes de champ d'étalonnage prédéterminées asymétriques différentes ($B_{Kxa2}$, $B_{Kxb2}$) dans le premier élément capteur (106a) et dans le deuxième élément capteur (106b) par rapport au troisième axe spatial (x) dans le troisième aménagement d'éléments capteurs (106).

**8.** Capteur de champ magnétique (100) selon l'une des revendications 1 à 7, le premier, le deuxième ou le troisième aménagement d'éléments capteurs (104; 106) présentant au moins deux éléments capteurs de Hall verticaux par rapport à une surface principale du capteur de champ magnétique, la disposition géométrique des au moins deux éléments capteurs de Hall verticaux étant symétrique par paire par rapport au point de référence (101), et qui sont couplés l'un à l'autre de sorte que la composante de champ magnétique puisse être captée compensée en décalage.

**9.** Procédé pour capter une première et une deuxième composante spatiale ($B_y$, $B_z$; $B_x$, $B_y$) d'un champ magnétique à un point de référence (101), le champ magnétique présentant une première et une deuxième composante de champ de mesure ($B_{My}$, $B_{Mz}$; $B_{Mx}$, $B_{My}$) et/ou une première et une deuxième composante de champ d'étalonnage ($B_{Ky}$, $B_{Kz}$; $B_{Kx}$, $B_{Ky}$), aux étapes suivantes consistant à:

capter, dans un premier et un deuxième élément capteur (104a, 104b; 106a, 106b) d'un premier aménagement d'éléments capteurs (104; 106), une première paire de composantes de champ magnétique ($B_{ya}$, $B_{yb}$; $B_{xa}$, $B_{xb}$) présentant des premières composantes de champ mesure ($B_{Mya}$, $B_{Myb}$; $B_{Mxa}$, $B_{Mxb}$) et/ou des premières composantes de champ d'étalonnage ($B_{Kya}$, $B_{Kyb}$; $B_{Kxa}$, $B_{Kxb}$), par rapport à un premier axe spatial (y; x) au point de référence (101);

capter, dans un deuxième aménagement d'éléments capteurs (102; 104) des deuxièmes composantes de champ magnétique ($B_z$; $B_y$) présentant des deuxièmes composantes de champ mesure ($B_{Mz}$; $B_{My}$) et/ou des deuxièmes composantes de champ d'étalonnage ($B_{Kz}$; $B_{Ky}$), par rapport à un deuxième axe spatial (z; y) au point de référence (101), les deux axes spatiaux (y, z; x, y) s'étendant le long de vecteurs de lieu linéairement indépendants; et

générer une première paire de composantes de champ d'étalonnage asymétriques différentes ($B_{Kya}$, $B_{Kyb}$; $B_{Kxa}$, $B_{Kxb}$) par rapport au premier axe spatial (y; x) dans le premier et le deuxième élément capteur (104a, 10ba; 106a, 106b) du premier aménagement d'éléments capteurs (104; 106).

**10.** Procédé selon la revendication 9, aux étapes suivantes consistant à:

capter une deuxième paire de composantes de champ magnétique ($B_{za}$, $B_{zb}$; $B_{ya}$, $B_{yb}$) présentant des deuxièmes composantes de champ de mesure ($B_{Mza}$, $B_{Mzb}$; $B_{Mya}$, $B_{Myb}$) et/ou des deuxièmes composantes de champ d'étalonnage ($B_{Kza}$, $B_{Kzb}$; $B_{Kya}$, $B_{Kyb}$), par rapport au deuxième axe spatial (z; y) au point de référence (101); et générer la deuxième paire de composantes de champ d'étalonnage asymétriques différentes ($B_{Kza}$, $B_{Kzb}$; $B_{Kya}$, $B_{Kyb}$) par rapport au deuxième axe spatial (z; y).

**11.** Procédé selon l'une des revendications 9 ou 10, par ailleurs aux étapes suivantes consistant à:

capter une troisième composante spatiale ($B_x$; $B_z$) du champ magnétique au point de référence (101), le champ magnétique présentant par ailleurs une troisième composante de champ de mesure ($B_{Mx}$; $B_{Mz}$) et/ou une troisième composante de champ d'étalonnage ($B_{Kx}$; $B_{Kz}$); et générer des troisièmes composantes de champ d'étalonnage ($B_{Kx}$; $B_{Kz}$) par rapport à un troisième axe spatial (x; z), les trois axes spatiaux (z, y, x) s'étendant le long de vecteurs de lieu linéairement indépendants.

**12.** Procédé selon la revendication 11, par ailleurs aux étapes suivantes consistant à:

capter une troisième paire de composantes de champ magnétique ($B_{xa}$, $B_{xb}$; $B_{za}$, $B_{zb}$) présentant des troisièmes composantes de champ de mesure ($B_{Mxa}$, $B_{Mxb}$; $B_{Mza}$, $B_{Mzb}$) et/ou des troisièmes composantes de champ d'étalonnage ($B_{Kxa}$, $B_{Kxb}$; $B_{Kza}$, $B_{Kzb}$), par rapport au troisième axe spatial (x; z) au point de référence (101); et générer la troisième paire de composantes de champ d'étalonnage asymétriques différentes ($B_{Kxa}$, $B_{Kxb}$; $B_{Kza}$, $B_{Kzb}$) par rapport au troisième axe spatial (x; z).

**13.** Procédé selon les revendications 9 à 12, par ailleurs aux étapes suivantes consistant à:

effectuer une première combinaison linéaire des signaux de mesure, associés aux composantes de champ magnétique, d'une composante de champ magnétique, pour obtenir une première valeur de mesure totale, pour réduire l'influence de la composante de champ de mesure dans la première valeur de mesure totale; ou effectuer une deuxième combinaison linéaire des signaux de mesure, associés aux autres composantes de champ magnétique, d'une composante de champ magnétique, pour obtenir une deuxième valeur de mesure totale, pour réduire l'influence de la composante de champ d'étalonnage dans la deuxième valeur de mesure totale.

**14.** Procédé selon l'une des revendications 9 à 13, par ailleurs aux étapes suivantes consistant à:

mémoriser les intensités de courant d'excitation, les composantes de champ de mesure ou les composantes de champ d'étalonnage pour l'étalonnage; associer les intensités de courant d'excitation aux composantes de champ d'étalonnage ou intensités de champ magnétique; et préparer des paires de valeurs de composantes de champ de mesure et d'intensités de champ magnétique.

**15.** Programme d'ordinateur avec un code de programme pour réaliser toutes les étapes d'un procédé selon les revendications 9 à 14 lorsque le code de programme est exécuté sur un ordinateur.

## FIG 1A

# FIG 1B

# FIG 1C

## FIG 1D

$Y, B_y, B_{Ky}, B_{My}$

$Z, B_z$

$X, B_x, B_{Kx}, B_{Mx}$

$B_{Kz}, B_{Mz}$

FIG 2

# FIG. 3A

# FIG 3B

# FIG 4

FIG 5

# FIG 6A
## (Stand der Technik)

# FIG 6B
## (Stand der Technik)

# FIG 7
## (Stand der Technik)

702

Einzelsensor

Sensor
Besteht aus 4
3-Pinnern

Mittelpunkte

Y

Z

X

704        706

Y

Z ⊙ → X

## FIG 8
(Stand der Technik)

# FIG 9
## (Stand der Technik)

902

3 getrennte
Sensoren

Mittelpunkte

906

904

902a

904

906b

Pixelzelle

900

906a

Mittelpunkte

902b

Y

Z ⊙ → X

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10150955
- DE 10150950
- DE 19943128

**In der Beschreibung aufgeführte Nicht-Patentliteratur**

- **R. S. Popovic.** Hall Effect Devices, Magnetic Sensors and Characterization of Semiconductors. Adam Hilger, 1991
- **C. Schott ; R. S. Popovic.** Integrated 3D Hall Magnetic Field Sensor. *Transducers '99,* 07. Juni 1999, vol. 1, 168-171
- **Enrico Schurig.** Highly Sensitive Vertical Hall Sensors in CMOS Technology. Hartung-Corre Verlag Konstanz, 2004, 185ff